# EUROPEAN PATENT APPLICATION

(11) **EP 4 528 363 A1**
(43) Date of publication of application: **26.03.2025**
(21) Application number: 24193073.4
(22) Date of filing: 06.08.2024
(51) Int. Cl.: G02F 1/025, G02B 6/12, G02B 6/43

(54) **SELECTIVE TRANSFER OF OPTICAL AND OPTO-ELECTRONIC COMPONENTS**

(30) Priority: 25.09.2023 US 202318473711
(71) Applicant: INTEL Corporation, Santa Clara, CA 95054 (US)
(72) Inventor: BALAMURUGAN, Ganesh, Hillsboro, 97124 (US); SWAN, Johanna, Scottsdale, 85255 (US); BRAUNISCH, Henning, Phoenix, 85018 (US); JAUSSI, James, Hillsboro, 97124 (US); ELSHERBINI, Adel, Chandler, 85248 (US); EID, Feras, Chandler, 85226 (US); LIFF, Shawna, Scottsdale, 85255 (US); THEN, Han Wui, Portland, 97229 (US); SOUNART, Thomas, Chandler, 85226 (US); TALUKDAR, Tushar, Wilsonville, 97124 (US)
(74) Representative: HGF

(57) **Abstract**

Methods of selectively transferring integrated circuit (IC) components between substrates, and devices and systems formed using the same, are disclosed herein. In one embodiment, a first substrate with a release layer and a layer of IC components over the release layer is received, and a second substrate with one or more adhesive areas is received. The layer of IC components may include one or more waveguides, ring resonators, drivers, photodetectors, transimpedance amplifiers, and/or electronic integrated circuits. The first substrate is partially bonded to the second substrate, such that a subset of IC components on the first substrate are bonded to the adhesive areas on the second substrate. The first substrate is then separated from the second substrate, and the subset of IC components bonded to the second substrate are separated from the first substrate and remain on the second substrate.

## Description

### BACKGROUND

In semiconductor manufacturing, layer transfer techniques are used to transfer a layer from one substrate to another, typically at wafer-level scale. These techniques require a full layer to be transferred in its entirety regardless of whether the entire layer is needed. As a result, any unneeded portions of a transferred layer must be etched off after the transfer, which increases costs and process complexity.

### BRIEF DESCRIPTION OF THE DRAWINGS

FIGS. 1A-I illustrate an example process flow for selective layer transfers using selective release techniques.
FIGS. 2A-I illustrate an example process flow for selective layer transfers using a blanket laser exposure.
FIGS. 3A-I illustrate an example process flow for selective layer transfers from a singulated donor substrate.
FIGS. 4A-C illustrate an example process flow for selective layer transfers from multiple donor substrates.
FIGS. 5A-F illustrate an example process flow for forming an integrated circuit package using a selective transfer of a passive interposer.
FIGS. 6A-B illustrate an example of a selective layer transfer between wafers.
**FIG. 7** illustrates a flowchart for performing selective layer transfers.
**FIG. 8** illustrates an example embodiment of an optical transceiver.
FIGS. 9A-F illustrate an example process flow for forming an optical transceiver using selective transfer technology.
FIGS. 10A-E illustrate various configurations of electrical and optical components integrated using selective transfer technology.
FIGS. 11A-B illustrate single-layer and multi-layer arrangements of selectively-transferred optical components.
FIGS. 12A-B illustrate a compute platform with an optical interconnect in accordance with certain embodiments.
FIGS. 13A-B illustrate an example embodiment of an optical package in accordance with certain embodiments.
**FIG. 14** illustrates a top view of a wafer and dies that may be included in a microelectronic assembly.
**FIG. 15** illustrates a cross-sectional side view of an integrated circuit device that may be included in a microelectronic assembly.
**FIG. 16** illustrates a cross-sectional side view of an integrated circuit device assembly that may include a microelectronic assembly.
**FIG. 17** illustrates a block diagram of an example electrical device that may include a microelectronic assembly.

### DETAILED DESCRIPTION

### Selective Layer Transfer

In semiconductor manufacturing, layer transfer techniques are used to transfer a layer from one substrate to another, typically at wafer-level scale. Layer transfers are useful for a variety of applications in semiconductor manufacturing, including two-dimensional (2D) material fabrication, Group III-V semiconductors over complementary metal-oxide semiconductors (CMOS), and traditional CMOS applications such as metal-insulator-metal (MIM) devices and thin device and/or interconnect layer transfers. Current layer transfer techniques are limited to full layer transfers, however, which may impact cost and performance when the full layer is not needed. For example, blanket layer transfer techniques, such as ion-cut and laser debonding layer transfers, require a full layer to be transferred in its entirety. As a result, any unneeded areas of the transferred layer must be etched off after the transfer, which results in added cost and process complexity.

Alternatively, pick-and-place techniques can be used to transfer specific dies or chiplets. For example, a chiplet generally refers to an integrated circuit (IC) that contains a well-defined subset of functionality, which is designed to be combined with other chiplets to form a single IC package. To transfer chiplets (e.g., for MIM chiplet integration in a system-on-a-chip (SoC)), chiplet devices are fabricated on a donor substrate (e.g., a wafer or panel), the donor substrate is singulated into chiplets, and the chiplets are then individually attached to a receiver substrate (e.g., an SoC wafer or package) using pick-and-place machines. This adds significant cost due to the extra processing required to singulate the wafer and individually attach the respective chiplet dies. For example, chiplets are generally manufactured on relatively thick substrates to enable them to be handled during the singulation and attach steps without being damaged, and after the attach step, additional processing is performed to thin the chiplets and/or remove the carrier substrate, which further increases the cost and process complexity. In particular, chiplets are typically manufactured on substrates that are over 700 micrometers (µm or microns) thick to provide structural and mechanical stability during fabrication, and after the singulation/attach steps, they may be thinned to approximately 20-100 µm by grinding the backside. However, grinding typically causes chipping along the edges of the chiplet dies. Further, it can be challenging to thin chiplets beyond 20 µm without producing defects. Similarly, chiplets are typically singulated with a die area on the millimeter level scale, as pick-and-place assembly becomes very challenging for chiplets smaller than 1 millimeter (mm)².

Integrated circuits can also be manufactured monolithically, where all IC components and interconnections are fabricated sequentially on the same underlying substrate or wafer. Monolithic ICs have various limitations, however, including design limitations due to incompatible processes, lack of flexibility, and low yield.

Accordingly, this disclosure presents selective layer transfer techniques for selectively transferring portions of a layer between substrates, along with devices and systems formed using the same. For example, the described techniques enable select areas of a donor substrate to be transferred to a receiver substrate, which enables the donor substrate to be reused multiple times, while also addressing the limitations described above for blanket layer transfers and pick and place techniques. In particular, the described solution uses a selective release technology on a donor substrate (e.g., wafer, panel, or die) in conjunction with a patterned bonding template on a receiver substrate (e.g., wafer, panel, or die) to allow select areas of a layer on the donor substrate to be transferred to the receiver substrate. For purposes of this disclosure, a layer may refer to one or more layers formed over a substrate, such as an individual layer of material, or a stack of layers that collectively form a layer of IC components (e.g., dies, interconnects, bridges, capacitors, and/or other semiconductor devices). A layer may also include stacked wafers, such as wafer-to-wafer bonded and stacked logic and/or memory wafers. As an example, a donor wafer may include a layer of IC components (e.g., IC dies), and a selective layer transfer may be used to selectively and simultaneously transfer a specific subset of those IC components to a receiver wafer.

The described solution provides various advantages. For example, the described solution enables select areas of a donor wafer to be transferred as opposed to an entire layer, which enables the donor wafer to be reused for multiple products, thus amortizing the cost of expensive devices (e.g., high-density MIM capacitors or high-density passive interposers) across multiple wafers. This solution also eliminates the need to etch away superfluous areas as required by full layer transfers (and as a result, unlike the etched areas after a full layer transfer, selectively transferred areas may not have tapered edges from etching or may have reversed tapering due to the etch to singulate before transfer).

Further, layers of IC components can be selectively transferred at any level of granularity, including full IC dies and packages, interconnects, transistors, resistors, capacitors, partial layers or layer stacks, etc.

This solution also enables areas of ultra-thin layers to be selectively transferred without the added processing and yield loss resulting from the handling challenges of chiplet pick-and-place methods (e.g., singulation, individually attaching each chiplet, post-attach thinning of chiplets). This helps reduce the Z-height of a product (e.g., for formfactor, thermal, and/or power delivery reasons) as well as the overall process complexity. For example, very thin IC dies or chiplets can be formed on any substrate and selectively transferred directly from that substrate. As a result, selectively transferring the dies not only eliminates the need for post-attach thinning, it also enables the dies to be much thinner than dies that are singulated, pick-and-place attached, and then subsequently thinned. In some cases, for example, the described solution may enable transfers of dies with thicknesses ranging from 100 nanometers (nm) to 5 µm or more. Further, since no post-attach thinning is needed, the selectively transferred dies may have no or minimal chipping on the die edges since no grinding is performed, unlike chiplets that are thinned after attachment.

Similarly, this solution supports selective transfers of very small areas on a donor substrate, such as very small dies or chiplets, which is extremely challenging using pick-and-place techniques. In some cases, for example, the described solution may enable transfers of dies (or other IC components) with an area less than 1 mm², such as 100 µm² (10x10 µm), 10,000 µm² (100x100 µm), 810,000 µm² (900x900 µm), etc. (with no limits on the maximum size of an area that can be selectively transferred).

This solution also supports selective transfers of dies with non-standard shapes and designs that are difficult to handle using pick-and-place machines, such as dies with atypical, arbitrary, irregular, or non-convex shapes (e.g., L shape, U shape, shapes with acute angles), dies with high aspect ratios (e.g., 8:1 aspect ratio or higher), dies with holes, and so forth.

Further, this solution has very low topography and supports high surface cleanliness and planarization (e.g., using chemical mechanical polishing (CMP) processing), which makes it compatible with hybrid bonding and fusion bonding processing. Additional advantages are described throughout this disclosure and apparent from the description below.

Accordingly, this solution enables complex IC packages and products to be manufactured by selectively transferring certain components (e.g., active circuitry such as IC dies, passive circuitry) instead of incorporating them using traditional processes, such as: (i) full layer transfers with superfluous areas etched away; (ii) pick-and-place assembly of individual IC components; and/or (iii) monolithic IC fabrication.

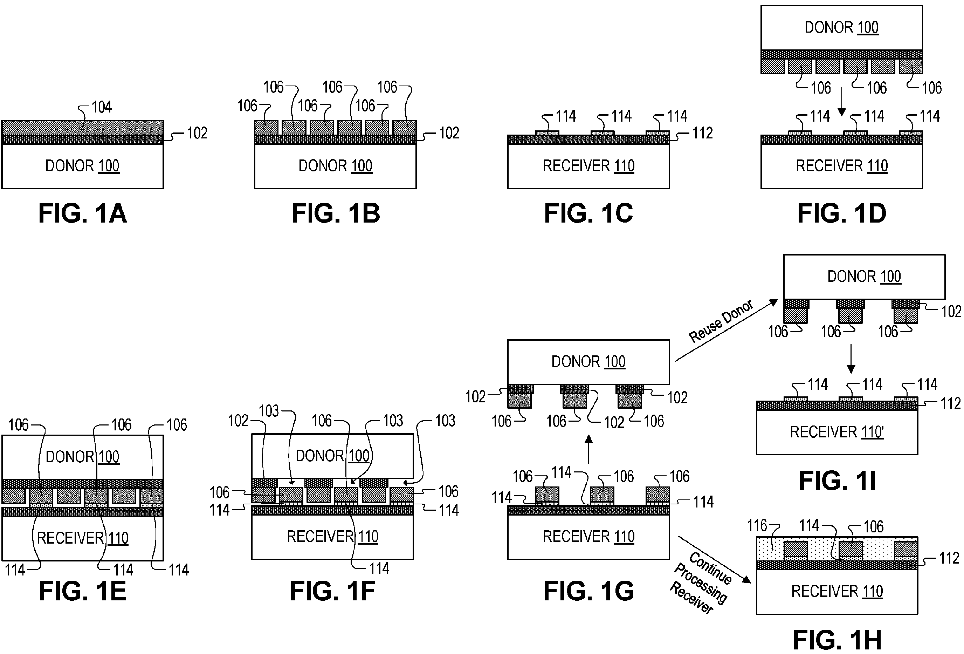

FIGS. 1A-I illustrate an example process flow for selective layer transfers using selective release techniques. In the illustrated example, a layer of integrated circuit (IC) components is selectively transferred from a donor substrate 100 to a receiver substrate 110, as described further below.

In FIG. 1A, a release layer 102 is formed over a carrier substrate, which is referred to as the donor substrate 100. The release layer 102 is a temporary bonding and debonding layer for the layer 104 to be selectively transferred. In some embodiments, the release layer 102 may include one or more layers and/or materials capable of providing adhesion to the donor substrate 100 and/or absorbing energy from a laser (e.g., laser beams), such as lossy dielectric and/or thin metal layer(s) that provide adhesion and absorb/reflect infrared (IR) light, organic polymer layer(s) (e.g., polyimides) that provide adhesion and absorb visible or ultraviolet (UV) light, and/or patterned dielectric layer(s) with anchors to provide residual adhesion (e.g., after the metal layer is ablated by an IR laser).

The layer 104 to be selectively transferred is formed over the release layer 102 of the donor substrate 100, such as by fabricating the layer 104 directly or blanket transferring the layer 104. The selective transfer layer 104 may include one or more layers of material, such as a single layer of material or a stack of layers that collectively form a layer of IC components (e.g., full IC dies, chiplets, interconnects, bridges, capacitors, transistors, and/or other semiconductor devices). In some embodiments, for example, the selective transfer layer 104 may be a prefabricated semiconductor wafer containing unsingulated integrated circuit (IC) dies, which is blanket transferred to the release layer 102 on a donor wafer 100.

In FIG. 1B, the selective transfer layer 104 is diced over the donor substrate 100-without dicing through the donor substrate 100-to partially singulate the IC components 106 in the layer 104, using techniques such as etching, reactive ion etching (RIE), plasma dicing, mechanical sawing, etc. In some embodiments, the release layer 102 may also be singulated (e.g. diced or etched) along with the transfer layer 104.

In FIG. 1C, a release layer 112 is optionally formed over another carrier substrate, which is referred to as the receiver substrate 110. For example, the release layer 112 may be formed over the receiver substrate 110 if the selectively transferred IC components 106 will be subsequently debonded from the receiver substrate 110 after the transfer. Otherwise, if the selectively transferred IC components 106 will remain on the receiver substrate 110 after the transfer, the release layer 112 on the receiver 110 may be omitted.

Next, a bonding template 114 is formed on the surface of the receiver substrate 110 (e.g., above the release layer 112, if included). The bonding template 114 includes a pattern of bonding features or adhesive areas 114 that enable specific areas of the donor substrate 100 to be selectively transferred to the receiver substrate 110. For example, the positions of the bonding features 114 on the receiver substrate 110 correspond to the areas or IC components 106 on the donor substrate 100 that will be transferred to the receiver substrate 110.

In some embodiments, for example, the bonding features 114 may include "island" or "mesa" structures that are similar in size to the target areas to be transferred from the donor substrate 100. For example, each island or mesa structure 114 may be a raised structure on the surface of the receiver substrate 110 with a similar footprint (e.g., shape/surface area) as a corresponding IC component 106 on the donor substrate 100. In other embodiments, the mesas 114 may be replaced by lithographically or additively manufactured surface treatments that enhance the adhesion in the target areas of the receiver substrate 110 (e.g., the areas where the mesas 114 are shown) and prevents adhesion in the other areas, including, without limitation, surface topography variations, use of materials with high and/or low adhesion, treatments using hydrophobic materials and/or self-assembled monolayers (SAMs), and/or surface activation techniques, among other examples.

In various embodiments, these bonding features 114 may be made of dielectric materials, conductive materials (e.g., metal), or both, depending on whether electrical connections are needed between the bonded IC components 106 and the receiver substrate 110. For example, the bonding features 114 may be blanket dielectric structures with no electrical contacts, or they may be dielectric structures with electrical contacts through them (e.g., hybrid bonding pads) if electrical connections are needed through the bonding interface.

In FIG. 1D, the donor and receiver substrates 100, 110 are brought into contact with each other with their top surfaces aligned face to face, such that the target IC components 106 on the donor 100 are aligned with corresponding bonding features 114 on the receiver 110.

In FIG. 1E, the donor and receiver substrates 100, 110 are partially bonded together. For example, the areas of the receiver substrate 110 with protruding surface features or "mesas" 114 are bonded to corresponding areas of the donor substrate 110 with the target IC components 106, while other areas of the donor and receiver substrates 100, 110 remain unbonded. In some embodiments, for example, this is controlled through the height of the bonding protrusions 114 to prevent unwanted contact between areas that are not to be transferred. As previously mentioned, this can also be controlled through surface treatment of the different areas to enable good adhesion in the target areas (e.g., where the mesas 114 are shown) and prevent or reduce adhesion in other areas.

In FIG. 1F, the IC components 106 bonded to the receiver 110 are selectively debonded from the donor 100 using selective release techniques, such as IR debonding, selective visible or ultraviolet (UV) laser exposure, etc. For example, areas 103 of the release layer 102 where those IC components 106 are bonded to the donor 100 may be selectively removed or ablated using a laser, such as an IR or UV laser, which forms gaps or voids 103 in the release layer 102 and causes those IC components 106 to be released from the donor 100.

In FIG. 1G, the donor and receiver substrates 100, 110 are mechanically separated from each other. At this point, the IC components 106 that were selectively bonded to the receiver 110 (e.g., via the bonding structures 114) and debonded from the donor 100 remain on the receiver 110 and are separated from the donor 100. All other IC components 106 that were not bonded to the receiver 110 remain on the donor 100.

In FIG. 1H, the receiver substrate 110 is now ready for continued processing, such as dielectric fill 116 around the transferred IC components 106, planarization, selectively transferring or pick-and-place attaching additional IC dies or other IC components, via formation, formation of interconnect/metallization layers, attaching a structural substrate, debonding the receiver substrate (e.g., via the optional receiver release layer 112), and/or any other processing required for the finished product (e.g., an IC package).

In FIG. 1I, the donor substrate 100 is then reused to transfer the remaining IC components 106 (e.g., the remaining areas of the selectively transferred layer 104) to a new receiver substrate 110'. The donor substrate 100 can continue being reused in this manner until all IC components 106, or the entire layer 104, have been selectively transferred to any number of receiver substrates 110.

It should be appreciated that the illustrated process flow for selective layer transfers is merely presented as an example and many other process variations are also possible. For example, the donor and receiver substrates 100, 110 may be wafers, panels, IC packages, chiplets, dies, or any combination thereof (e.g., for transfers from wafer to panel, chiplet to wafer, etc.). Moreover, each substrate 100, 110 may be made of a variety of materials, including, without limitation, inorganic materials such as silicon, silicon on insulator (SOI), quartz, glass, and/or Group III-V materials, organic materials such as IR or UV transparent epoxies, and so forth.

The materials used in the release layers 102, 112 may vary depending on the type of release or debonding technology used. For example, for infrared (IR) laser debonding, the release layers 102, 112 may include one or more materials capable of absorbing and/or reflecting infrared (IR) light, such as a thin metal layer or multiple metal layers (e.g., aluminum (Al), tungsten (W), copper (Cu), titanium (Ti), titanium nitride (TiN), tantalum (Ta), tantalum nitride (TaN)). For ultraviolet (UV) laser debonding, the release layers 102, 112 may include one or more materials capable of absorbing UV light (e.g., a wide range of organic polymers, including, but not limited to, polyimides). In some embodiments, the release layers 102, 112 may additionally or alternatively include one or more layers of dielectric materials (e.g., silicon dioxide (SiOz), silicon nitride (Si₃N₄), silicon oxynitride (SiON), silicon carbide (SiC), silicon carbon nitride (SiCN), silicon oxycarbon nitride (SiOCN), aluminum oxide (Al₂O₃), low-k dielectrics such as carbon-doped oxide (CDO) or porous silicon dioxide (SiOz), titanium dioxide (TiO₂), tantalum oxide (Ta₂O₅)), which may be used to buffer laser ablation and thermal energy, control thin film interference or adhesion, and/or provide residual adhesion after other materials and/or layers in the release layers 102, 112 are weakened, removed, and/or ablated by a laser.

The number of layers 104 on the donor substrate 100, the arrangement/structure of the layers 104, the materials in each layer 104, and the type of IC components 106 formed in those layers 104 may vary.

The adhesive areas or bonding features 114 on the receiver substrate 110 may be formed using any suitable surface treatments or other techniques to control the level of adhesion in different areas, including, without limitation, surface topography variations (e.g., mesas, recesses), use of materials with high and/or low adhesion, treatments using hydrophobic materials and/or self-assembled monolayers (SAMs), and/or surface activation techniques, among other examples. Moreover, the bonding features or adhesive areas 114 on the receiver substrate 110 may vary in size, shape, height, topography, pattern, and materials. For example, the bonding features 114 may be formed using inorganic dielectrics such as silicon dioxide (SiOz), silicon nitride (Si₃N₄), silicon oxy nitride (SiON), and/or silicon carbon nitride (SiCN), organic dielectrics such as photoresists and adhesives, conductive materials such as metals, and combinations thereof.

The donor and receiver substrates 100, 110 may be (partially) bonded using any suitable bonding techniques, including, without limitation, hybrid bonding, fusion bonding, and adhesive bonding. The donor and receiver substrates 100, 110 may be debonded or released using any suitable debonding techniques, including, without limitation, IR and UV laser debonding. Further, there may be additional cleaning steps to reuse the donor substrate 100 before or after each selective layer transfer to a receiver substrate 110.

Further, in some embodiments, additional bonding and/or alignment features may be included at the wafer level and/or die level (e.g., on the donor dies, donor wafer, receiver wafer, and/or final product). For example, the donor and/or receiver wafer may include ridge or cross structures to facilitate bonding, such as a single ridge (e.g., a line or strip of dielectric material) extending across and/or through the center of the wafer, or multiple orthogonal ridges forming a cross-like pattern. Alignment features for wafers, die-lets, and/or die arrays may also be included to facilitate bonds with proper alignment. Further, multiple dies may be connected by small (e.g., dielectric) bridges to help them collectively bond and transfer together. For example, if some of the bridge-connected dies successfully bond to the receiver, the bridges may help others bond as well. Thus, these inter-die bridges may be present on the donor before the transfer, and on the receiver and final product after the transfer.

Further, in some cases, the debonding process may cause some unique damage or delamination near the edge and/or on the back of the dies, which does not impact process performance but may be indicative of this solution being used.

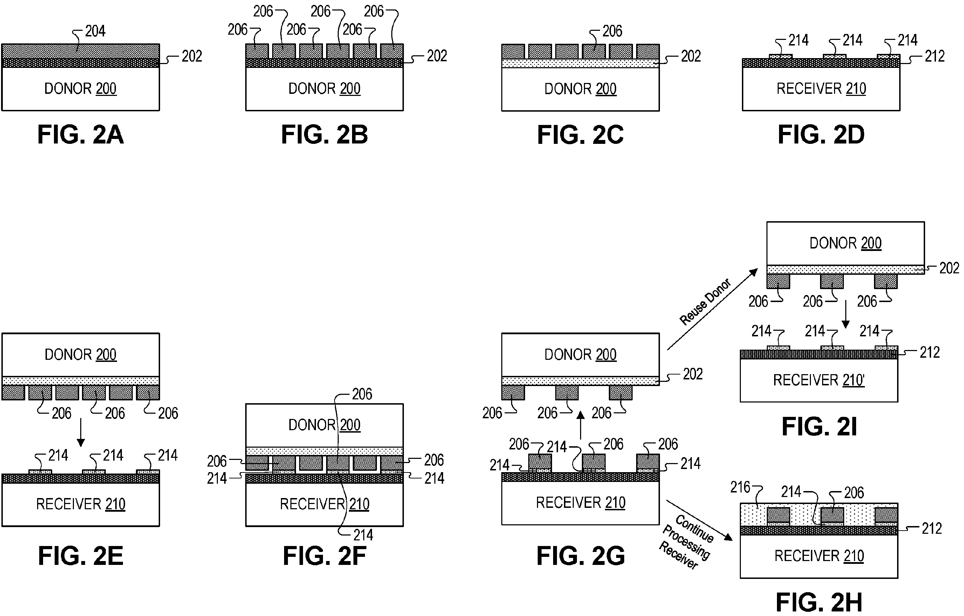

FIGS. 2A-I illustrate an example process flow for selective layer transfers using a blanket laser exposure. In the illustrated example, a layer 204 of integrated circuit (IC) components 206 is selectively transferred from a donor substrate 200 to a receiver substrate 210. Prior to the transfer, however, the entire release layer202 on the donor 200 is mechanically weakened (e.g., using IR laser, visible light laser, UV laser, chemical etching, and/or thermal techniques), which may also be referred to as a partial release. In this manner, after the target IC components 206 on the donor200 are bonded to the receiver 210, they can be fully released from the donor 200 by mechanically separating the donor200 from the receiver 210. In some cases, this may result in a simplified and faster bond/debond flow compared to the bond/selective release/debond flow of FIGS. 1A-I. Alternatively, ratherthan using blanket laser exposure, the respective materials used in the donor release layer 202 and the receiver bonding template 214 may be selected such that the bond to the donor 200 is weaker than the subsequently formed bond to the receiver 210.

In FIG. 2A, a release layer 202 is formed over a donor substrate 200. The layer 204 to be selectively transferred is formed over the release layer 202, such as by fabricating the layer 204 directly or blanket transferring the layer 204. In some embodiments, the selective transfer layer 204 may be a layerofIC components (e.g., IC dies, chiplets, interconnects, bridges, capacitors, transistors, and/or other semiconductor devices).

In FIG. 2B, the selective transfer layer 204 is diced over the donor substrate 200-without dicing through the donor substrate 200-to partially singulate the IC components 206 in the layer 204.

In FIG. 2C, blanket laser exposure is performed on the donor release layer 202 to weaken the entire release layer 202 prior to the transfer. In some embodiments, for example, blanket laser exposure may be performed using laser (e.g., IR or UV laser exposure), chemical, and/or thermal techniques. In this manner, the weakened release layer 202 has lower bond energy, which results in a partial release of the IC components 206 bonded to that layer 202.

In FIG. 2D, a release layer 212 is optionally formed over a receiver substrate 210. For example, if the selectively transferred IC components 206 will be subsequently debonded from the receiver substrate 210 after the transfer, a release layer 212 may be formed over the receiver 210; otherwise, the release layer 212 on the receiver 210 may be omitted.

Next, a bonding template 214 is formed on the surface of the receiver substrate 210 (e.g., above the release layer 212, if included). The bonding template 214 includes a pattern of bonding features or adhesive areas 214, such as mesas, that enable specific areas of the donor substrate 200 to be selectively transferred to the receiver substrate 210. In various embodiments, however, any suitable surface treatments or other techniques may be used to control the level of adhesion on different areas of the receiver substrate 210 (e.g., to form adhesive and non-adhesive areas for selective transfers), including, without limitation, surface topography variations (e.g., mesas, recesses), use of materials with high and/or low adhesion, treatments using hydrophobic materials and/or self-assembled monolayers (SAMs), and/or surface activation techniques, among other examples.

In FIG. 2E, the donor and receiver substrates 200, 210 are brought into contact with each other with their top surfaces aligned face to face, such that the target IC components 206 on the donor 200 are aligned with corresponding bonding features 214 on the receiver 210.

In FIG. 2F, the donor and receiver substrates 200, 210 are partially bonded together, where the areas of the donor 200 with the target IC components 206 are bonded to the areas on the receiver 210 with bonding mesas 214.

In FIG. 2G, the donor and receiver substrates 200, 210 are mechanically separated from each other. At this point, the IC components 206 that were selectively bonded to the receiver 210 (e.g., via the bonding mesas 214) remain on the receiver 210 and are debonded/separated from the donor 200 due to the blanket weakening of the donor release layer 202. All other IC components 206 that were not bonded to the receiver 210 remain on the donor 200.

Alternatively, in some embodiments, instead of (or in addition to) performing blanket laser exposure in FIG. 2C, the respective materials used in the donor release layer 202 and the receiver bonding template 214 may be selected such that the target IC components 206 will have a stronger bond to the receiver 210 than the donor 200. In this manner, when the donor 200 and receiver 210 are mechanically separated, the target IC components 206 will debond from the donor 200 and remain on the receiver 210 due to the disparity in bond strength.

In FIG. 2H, the receiver substrate 210 is ready for continued processing, such as dielectric fill 216 around the transferred IC components 206, planarization, selectively transferring or pick-and-place attaching additional IC dies or other IC components, via formation, formation of interconnect/metallization layers, attaching a structural substrate, debonding the receiver substrate (e.g., via the optional receiver release layer 212), and/or any other processing required for the finished product (e.g., an IC package).

In FIG. 2I, the donor substrate 200 is then reused to transfer the remaining IC components 206 (e.g., the remaining areas of the selectively transferred layer 204) to a new receiver substrate 210'. The donor substrate 200 can continue being reused in this manner until all IC components 206, or the entire layer 204, have been selectively transferred to any number of receiver substrates 210.

Elements labeled with reference numerals in FIGS. 2A-I may be similar to those having similar reference numerals in FIGS. 1A-I. Further, it should be appreciated that the illustrated process flow for selective layer transfers is merely presented as an example and many other process variations are also possible, including, but not limited to, the process variations described throughout this disclosure.

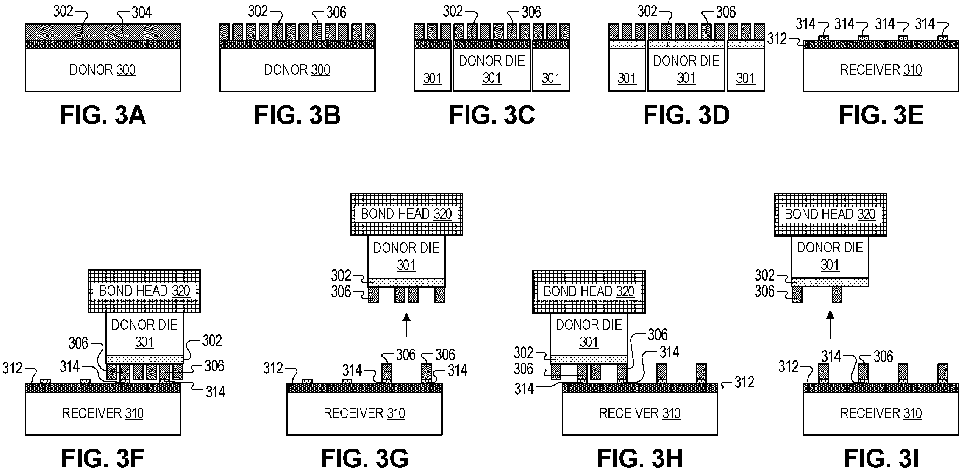

FIGS. 3A-I illustrate an example process flow for selective layer transfers from a singulated donor substrate 300. In some cases, for example, if the percentage of transferred integrated circuit (IC) components 306 is relatively small for each selective layer transfer, it may be easier and more cost efficient to dice the donor substrate 300 and perform the transfers from singulated donor dies 301 that contain smaller subsets of IC components 306 from the original donor substrate 300. Accordingly, in the illustrated example, a donor substrate 300 with a layer 304 of IC components 306 is diced, and the resulting layer of IC components 306 on a singulated donor die 301 is selectively transferred to a receiver substrate 310. In this manner, the transfers are performed at the donor die level rather than the wafer or panel level.

In FIG. 3A, a release layer 302 is formed over a donor substrate 300. The layer 304 to be selectively transferred is formed over the release layer 302, such as by fabricating the layer 304 directly or blanket transferring the layer 304. In some embodiments, the selective transfer layer 304 may be a layer of IC components (e.g., IC dies, chiplets, interconnects, bridges, capacitors, transistors, and/or other semiconductor devices).

In FIG. 3B, the selective transfer layer 304 is diced over the donor substrate 300-without dicing through the donor substrate 300-to partially singulate the IC components 306 in the layer 304. In some embodiments, the release layer 302 may also be singulated (e.g., diced or etched) along with the transfer layer 306.

In FIG. 3C, the donor substrate 300 is diced into singulated donor dies 301 that each contain a subset of the IC components 306 from the original donor substrate 300. For example, each donor die 301 may include one or more IC components 306 from the layer 304 on the original donor substrate 300.

In FIG. 3D, either blanket laser exposure (as shown) or a selective laser release is performed on the donor release layer 302 to weaken the entire release layer 302 prior to the transfer (e.g., using IR/UV laser exposure or thermal techniques), thus partially releasing the IC components 306 from the donor dies 301.

In FIG. 3E, a release layer 312 is optionally formed over a receiver substrate 310 (e.g., in the event the selectively transferred IC components 306 will be subsequently debonded from the receiver substrate 310 after the transfer). Next, a bonding template 314 is formed on the surface of the receiver substrate 310 (e.g., above the release layer 312, if included). The bonding template 314 includes a pattern of bonding features or adhesive areas 314, such as mesas, that enable specific areas of a donor die 301 to be selectively transferred to the receiver substrate 310. In various embodiments, however, any suitable surface treatments or other techniques may be used to control the level of adhesion on different areas of the receiver substrate 310 (e.g., to form adhesive and non-adhesive areas for selective transfers), including, without limitation, surface topography variations (e.g., mesas, recesses), use of materials with high and/or low adhesion, treatments using hydrophobic materials and/or self-assembled monolayers (SAMs), and/or surface activation techniques, among other examples.

In FIG. 3F, a bond head 320 is used to pick up one of the donor dies 301 and place it face down on the receiver substrate 310 such that the target IC components 306 on the donor die 301 are aligned with the corresponding bonding mesas 314 on the receiver substrate 310. The donor die 301 and receiver substrate 310 are then partially bonded together (e.g., die-to-wafer bond) with the target IC components 306 bonded to the receiver bonding mesas 314.

In FIG. 3G, the bond head 320 lifts up and mechanically separates the donor die 301 from the receiver substrate 310. At this point, the IC components 306 that were selectively bonded to the receiver 310 (e.g., via the bonding mesas 314) remain on the receiver 310 and are debonded/separated from the donor die 301 (e.g., die-to-wafer debond) due to the blanket weakening of the donor release layer 302. All other IC components 306 that were not bonded to the receiver substrate 310 remain on the donor die 301.

Alternatively, in some embodiments, instead of (or in addition to) performing blanket laser exposure in FIG. 3D, the target IC components 306 may be selectively released (e.g., as described with respect to FIG. 1F), or the donor release layer 302 and receiver bonding template 314 may be formed with materials having different bonding strengths such that the target IC components 306 will have a stronger bond to the receiver substrate 310 than the donor die 301.

In FIG. 3H and FIG. 3I, the bond head 320 steps and repeats. For example, the bond head 320 moves to a new position and repeats the process of FIG. 3F and FIG. 3G, respectively, to selectively transfer another group of IC components 306 from the donor die 301 to other areas of the receiver substrate 310.

The process may repeat in this manner until all IC components 306 on the donor die 301 have been transferred. At that point, the bond head 320 may pick up another donor die 301 and continue transferring IC components 306 from the new donor die 301 to the same or different receiver substrate 310.

After all transfers to the receiver substrate 310 are complete, the receiver 310 may be ready for continued processing, such as dielectric fill around the transferred IC components 306, planarization, selectively transferring or pick-and-place attaching additional IC dies or other IC components, via formation, formation of interconnect/metallization layers, attaching a structural substrate, debonding the receiver substrate (e.g., via the optional receiver release layer 312), and/or any other processing required for the finished product (e.g., an IC package).

Elements labeled with reference numerals in FIGS. 3A-I may be similar to those having similar reference numerals in FIGS. 1A-I. Further, it should be appreciated that the illustrated process flow for selective layer transfers is merely presented as an example and many other process variations are also possible, including, but not limited to, the process variations described throughout this disclosure.

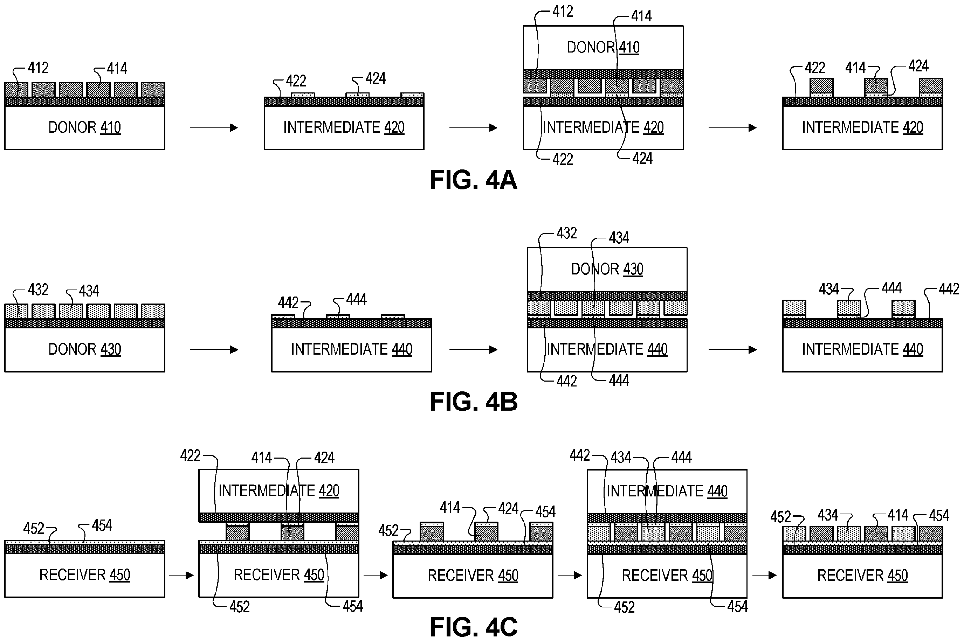

FIGS. 4A-C illustrate an example process flow for selective layer transfers from multiple donor substrates. In the illustrated example, integrated circuit (IC) components 414, 434 from multiple donor substrates 410, 430 are selectively transferred to a receiver substrate 450 using intermediate carrier substrates 420, 440. In some embodiments, the respective donors 410, 430 may have different types of IC components 414, 434, such as different types of IC dies or chiplets. In this manner, selective layer transfers can be used to transfer multiple types of IC components, such as different types of dies or chiplets, to the same receiver substrate 450. While the illustrated example depicts selective transfers from two types of donor substrates 410, 430 (e.g., with two types of types of IC components 414, 434), any number of donor substrates with any type of IC dies or other components are possible (including different die sizes).

In FIG. 4A, a layer of IC components 414 is selectively transferred from a first donor substrate 410 to an intermediate carrier substrate 420 (e.g., using any of the selective transfer flows described throughout the disclosure). For example, a release layer 412 is formed over the donor substrate 410. The layer 414 to be selectively transferred is then formed over the release layer 412 (e.g., by fabricating the layer 414 directly or blanket transferring the layer 414 from a wafer to the donor carrier 410) and diced into partially singulated IC components 414. Separately, a release layer 422 is formed over an intermediate carrier/receiver substrate 420, and a bonding template 424 is formed on the surface of the intermediate carrier 420 (e.g., above the release layer 422). The donor 410 and intermediate carrier 420 are then partially bonded together (e.g., with the target IC components 414 on the donor 410 bonded to the bonding features or adhesive areas 424 on the intermediate carrier 420). The donor 410 and intermediate carrier 420 are then debonded and separated from each other using any of the techniques described throughout this disclosure (e.g., selective release, blanket laser exposure, etc.). As a result, the target IC components 414 are debonded/separated from the donor 410 and remain on the intermediate carrier 420.

In FIG. 4B, another layer of IC components 434 is selectively transferred from a second donor substrate 430 to another intermediate carrier substrate 440 (e.g., using any of the selective transfer flows described throughout the disclosure). For example, a release layer 432 is formed over the donor substrate 430. The layer 434 to be selectively transferred is then formed over the release layer 432 (e.g., by fabricating the layer 434 directly or blanket transferring the layer 434 from a wafer to the donor carrier 430) and diced into partially singulated IC components 434. Separately, a release layer 442 is formed over an intermediate carrier/receiver substrate 440, and a bonding template 444 is formed on the surface of the intermediate carrier 440 (e.g., above the release layer 442). The donor 430 and intermediate carrier 440 are then partially bonded together (e.g., with the target IC components 434 on the donor 430 bonded to the bonding features or adhesive areas 444 on the intermediate carrier 440). The donor 430 and intermediate carrier 440 are then debonded and separated from each other using any of the techniques described throughout this disclosure (e.g., selective release, blanket laser exposure, etc.). As a result, the target IC components 434 are debonded/separated from the donor 430 and remain on the intermediate carrier 440.

In FIG. 4C, the IC components 414, 434 on both intermediate carriers 420, 440 are selectively transferred to a receiver substrate 450 (e.g., using any of the selective transfer flows described throughout the disclosure). For example, a release layer 452 is optionally formed over the receiver substrate 450 (e.g., in the event the selectively transferred IC components 414, 434 will be subsequently debonded from the receiver substrate 450 after the transfer). A bonding layer 454 (e.g., with adhesive areas / bonding features) is then formed on the surface of the receiver 450 (e.g., above the release layer 452, if included). Next, the IC components 414 on the first intermediate carrier 420 are selectively transferred to the receiver substrate 450 (e.g., using any of the selective transfer flows described throughout the disclosure). Finally, the IC components 434 on the second intermediate carrier 440 are selectively transferred to the receiver substrate 450 (e.g., using any of the selective transfer flows described throughout the disclosure).

Additional processing may then be performed on the receiver substrate 450, such as cleaning steps (e.g., removing the leftover bonding structures 424, 444 from the transferred IC components 414, 434), dielectric fill around the transferred IC components 414, 434, planarization, selectively transferring or pick-and-place attaching additional IC dies or other IC components, via formation, formation of interconnect/metallization layers, attaching a structural substrate, debonding the receiver substrate (e.g., via the optional receiver release layer 452), and/or any other processing required for the finished product (e.g., an IC package).

It should be appreciated that the illustrated process flow for selective layer transfers is merely presented as an example and many other process variations are also possible, including, but not limited to, the process variations described throughout this disclosure.

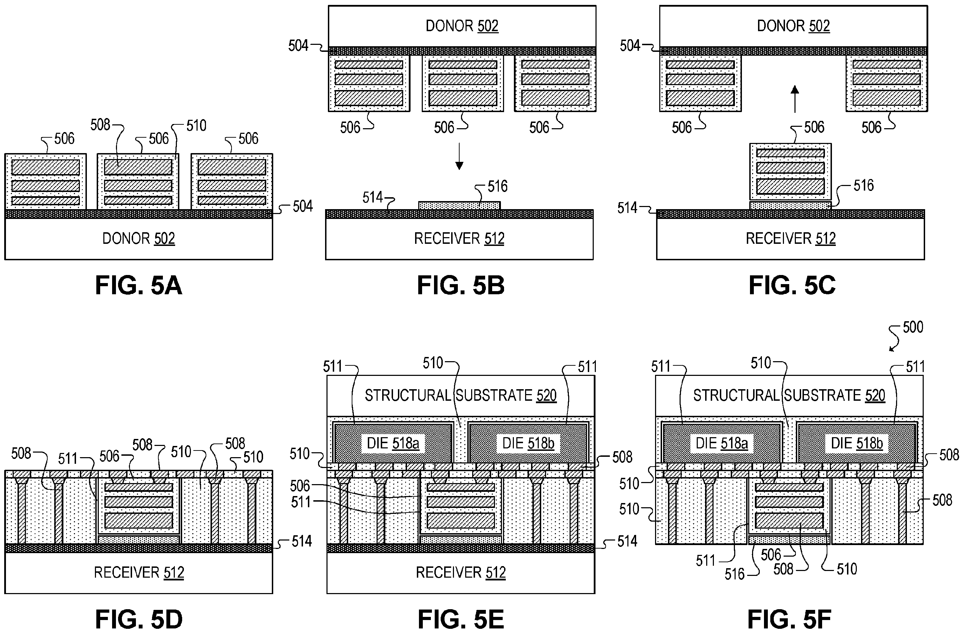

FIGS. 5A-F illustrate an example process flow for forming an integrated circuit (IC) package 500 with a selectively transferred passive interposer 506. Selective transfers can be used for a variety of applications, including transfers of active components (e.g., IC dies, transistors, diodes) and passive components (e.g., interconnects, metal-insulator-metal (MIM) chiplets, resistors, capacitors, inductors, transformers). In the illustrated example, the process flow is used to form an IC package 500 with a selectively-transferred low-cost passive interposer 506. For example, interposers 506 with high-density die-to-die (D2D) links 508 are created on a donor wafer 502 and then selectively transferred to a receiver wafer 512, which enables the same donor wafer 502 to be reused multiple times and amortizes the cost of the interconnect devices across multiple receiver wafers 512. In some embodiments, other components of the IC package 500 may also be selectively transferred, such as the IC dies 518a-b. Selective transfers can also be used for other applications, including, without limitation, transfers of photonic/optical components, and localized transfers of Group III-V semiconductors for radio frequency (RF) and high-power devices.

In FIG. 5A, repeated D2D interconnect patterns 506 are created on a release layer 504 of the donor substrate 502, and the resulting D2D interconnects are partially singulated (e.g., diced to, but not through, the donor substrate 502). The D2D interconnects 506 include high-density interconnect links 508 separated by dielectric layers 510.

In FIG. 5B, a transfer template 516 for a selective transfer is created on a release layer 514 of a receiver/carrier substrate 512. The transfer template 516 includes a dielectric bonding protrusion 516, referred to as a mesa, on the surface of the receiver substrate 512. In various embodiments, however, any suitable surface treatments or other techniques may be used to control the level of adhesion on different areas of the receiver substrate 512 (e.g., to form adhesive and non-adhesive areas for selective transfers), including, without limitation, surface topography variations (e.g., mesas, recesses), use of materials with high and/or low adhesion, treatments using hydrophobic materials and/or self-assembled monolayers (SAMs), and/or surface activation techniques, among other examples. Further, in various embodiments, any number of buildup layers may be formed on the receiver substrate 512 prior to forming the templated connection pedestal or mesa 516 for the selective transfer.

The bonding mesa 516 is used to selectively transfer a D2D interconnect 506 from the donor 502 to the receiver 512 (e.g., using any of the selective transfer flows described throughout this disclosure). For example, the donor 502 and receiver 512 are aligned face to face, stacked, and then partially bonded together such that one of the D2D interconnects 506 on the donor 502 is bonded to the bonding mesa 516 on the receiver 512.

In FIG. 5C, the D2D interconnect 506 bonded to the receiver mesa 516 is debonded and/or released from the donor release layer 504 using any of the techniques described herein (e.g., selective release, blanket laser exposure, formation of bonds with strength disparities), and the donor 502 and receiver 512 are mechanically separated. As a result, the transferred D2D interconnect 506 is separated from the donor 502 and remains on the receiver 512.

In FIG. 5D, additional processing is performed to form the remaining interconnect, including dielectric (e.g., oxide) fill 510 and planarization, interconnect 508 patterning/metallization (e.g., formation of through-dielectric vias (TDVs) 508, top metal contacts 508 such as hybrid bonding pads, dielectric layers 510), and so forth.

Notably, since the D2D interposer 506 was selectively transferred while the surrounding dielectric layers 510 were fabricated directly on the receiver 512, there is a seam 511 between the transferred D2D interposer 506 and the surrounding layers 510, as shown in FIG. 5D. In general, this type of seam or transition may be present around selectively transferred components of any type since they are not formed contemporaneously with the surrounding layers.

In FIG. 5E, multiple IC dies 518a-b are attached to the top metal pads 508 (e.g., via hybrid bonding), the area around the dies 518a-b is filled with dielectric material 510 (e.g., oxide) and planarized, and a structural substrate 520 is attached (e.g., a structural silicon wafer).

The dies 518a-b may be attached using standard assembly techniques, such as pick and place, or using the selective transfer techniques described herein (e.g., similar to the transferred D2D interconnect 506).

If the dies 518a-b are attached using pick-and-place assembly, they are typically formed on a thick substrate for handling purposes and then subsequently thinned after the attach.

If the dies 518a-b are selectively transferred, however, they can be formed on-and transferred directly from-a very thin substrate. As a result, selectively transferring the dies 518a-b not only eliminates the need for post-attach thinning, it also enables the dies 518a-b to be much thinner than dies that are pick-and-place attached and subsequently thinned. Further, if the dies 518a-b are selectively transferred, there may be a seam 511 between the dies 518a-b and portions of the layers 510 surrounding the dies 518a-b, similar to the seam 511 shown around the transferred D2D interconnect 506, as described above. Moreover, because the dies 518a-b are selectively transferred, they can be different types of dies, formed on separate pieces of substrate material (e.g., separate wafers or panels) using separate processes, and then selectively transferred to the same layer of an IC device 500.

In FIG. 5F, the receiver 512 is debonded and released from the release layer 514 (e.g., using any of the techniques described herein, such as IR or UV laser ablation).

At this point, the IC package 500 may be complete, or alternatively, additional processing may be performed. For example, if the processing is performed at the wafer or panel level, the resulting IC packages 500 on the structural substrate 520 may be singulated.

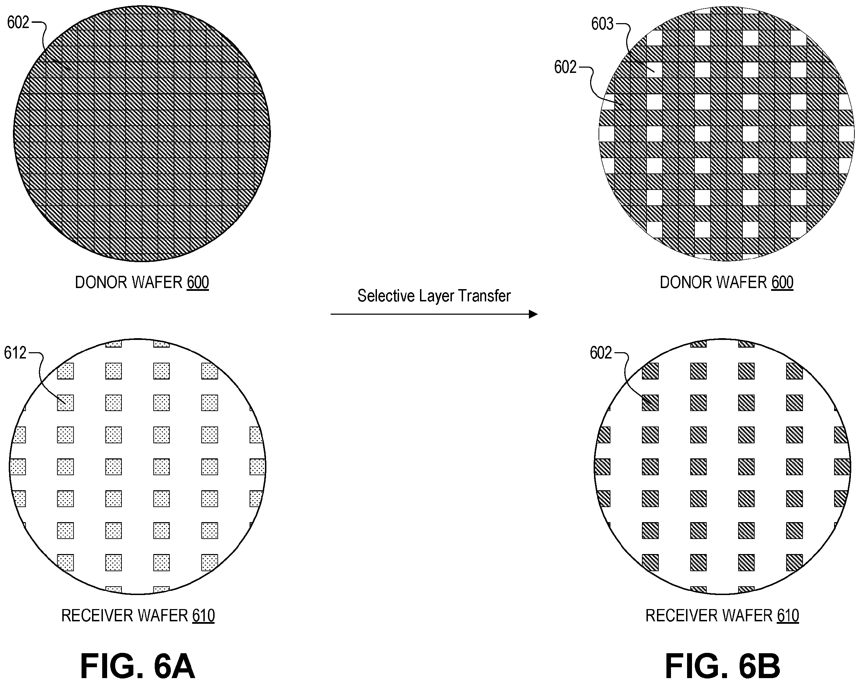

FIGS. 6A-B illustrate an example of a selective layer transfer between donor and receiver wafers 600, 610. In particular, FIG. 6A shows the wafers 600, 610 prior to the transfer, while FIG. 6B shows the wafers 600, 610 after the transfer. In the illustrated example, non-contiguous areas of the donor wafer 600 are selectively transferred to non-contiguous positions on the receiver wafer 610. In other embodiments, however, the target areas on the donor 600 and the destination areas on the receiver 610 may be partially contiguous or fully contiguous.

As shown in FIG. 6A, prior to the transfer, the donor wafer 600 includes a layer of integrated circuit (IC) components 602 (e.g., dies, chiplets, interconnects, capacitors, transistors, etc.), which may be partially singulated (e.g., diced down to, but not through, the underlying wafer 600). The receiver wafer 610 includes adhesive areas 612 patterned in non-contiguous positions on the surface (also referred to as a bonding template), which is where the target IC components 602 from the donor 600 will be transferred. In some embodiments, for example, the adhesive areas 612 may be raised structures or protrusions (referred to as "mesas") patterned on the surface of the receiver 612. Moreover, in some embodiments, the adhesive areas 612 on the receiver 610 may have a similar footprint as the target IC components 602 on the donor 600. In various embodiments, however, any suitable surface treatments or other techniques may be used to control the level of adhesion on different areas of the receiver substrate 610 (e.g., to form adhesive and non-adhesive areas for selective transfers), including, without limitation, surface topography variations (e.g., mesas, recesses), use of materials with high and/or low adhesion, treatments using hydrophobic materials and/or self-assembled monolayers (SAMs), and/or surface activation techniques, among other examples.

As shown in FIG. 6B, after the transfer, the target IC components 602 have been transferred from the donor wafer 600 to the receiver wafer 610. As a result, the donor wafer 600 includes empty areas 603 where the transferred IC components 602 were located, while the receiver wafer 610 includes the transferred IC components 602 in the positions where the adhesive areas 612 were patterned. In particular, individual IC components 602 from the donor wafer 600 are now bonded to individual adhesive areas 612 on the receiver wafer 610.

While the illustrated example depicts a selective transfer between two wafers, selective transfers can be performed between panels or other substrates of any shape or size, including substrates with mismatched shapes and sizes.

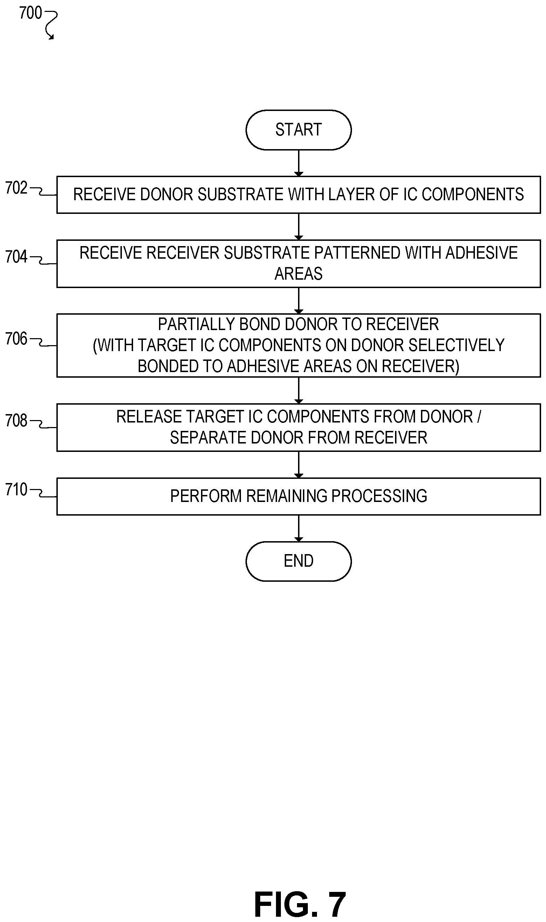

**FIG. 7** illustrates a flowchart 700 for performing selective layer transfers. It will be appreciated in light of the present disclosure that the illustrated process flow is only one example methodology for performing selective layer transfers. Moreover, the steps of the illustrated process flow may be performed using any suitable semiconductor fabrication techniques. For example, film deposition-such as depositing layers, filling portions of layers (e.g., removed portions), and filling via openings-may be performed using any suitable deposition techniques, including, for example, chemical vapor deposition (CVD), metal-organic chemical vapor deposition (MOCVD), molecular beam epitaxy (MBE), atomic layer deposition (ALD), and/or physical vapor deposition (PVD). Moreover, patterning and removal-such as interconnect patterning, forming via openings, and shaping-may be performed using any suitable techniques, such as lithography-based patterning/masking and/or etching.

The flowchart begins at block 702 by receiving a first substrate with a layer of integrated circuit (IC) components, which may be referred to as the donor substrate. In some embodiments, the donor substrate may include a base substrate, a release layer over the base substrate, and a (partially singulated) layer of IC components over the release layer.

In some embodiments, the donor substrate may be formed by receiving the base substrate, forming the release layer over the base substrate, forming the layer of IC components over the release layer (e.g., by fabricating or transferring the layer of IC components over the release layer), and partially singulating the layer of IC components (e.g., by dicing through the layer of IC components without dicing through the base substrate).

In various embodiments, the layer of IC components may include one or more IC dies, interconnects, transistors, diodes, resistors, capacitors, inductors, transformers, optical/opto-electrical components (e.g., optical waveguides, ring resonators, drivers, photodetectors, transimpedance amplifiers, electronic integrated circuits, optical transceivers, optical interfaces), and/or any other active or passive circuitry or components.

The base substrate may be made of one or more materials that include elements such as silicon (Si), oxygen (O), carbon (C), hydrogen (H), and/or Group III-V elements (e.g., aluminum (Al), gallium (Ga), indium (In), nitrogen (N), phosphorus (P), arsenic (As), antimony (Sb)), including, without limitation, silicon (Si), silicon dioxide (silica or SiOz), silicon on insulator (SOI), quartz, glass, Group III-V materials (e.g., gallium nitride (GaN), aluminum gallium nitride (GaN), gallium arsenide (GaAs), indium gallium arsenide (InGaAs), indium phosphide (InP)), and epoxies/resins (e.g., IR or UV transparent epoxies).

The release layer may include one or more layers of varying materials depending on the type of release or debonding technology used. For example, for IR laser debonding, the release layer may include one or more layers of material(s) capable of absorbing and/or reflecting infrared (IR) electromagnetic radiation, such as a thin metal layer or multiple metal layers (e.g., aluminum (Al), tungsten (W), copper (Cu), titanium (Ti), titanium nitride (TiN), tantalum (Ta), tantalum nitride (TaN)). For UV laser debonding, the release layer may include one or more layers of material(s) capable of absorbing ultraviolet (UV) electromagnetic radiation (e.g., organic polymers such as polyimides). In some embodiments, the release layer may additionally or alternatively include one or more layers of dielectric materials to buffer laser ablation and thermal energy, control thin film interference or adhesion, and/or provide residual adhesion after other materials and/or layers in the release layers are weakened, removed, and/or ablated by a laser (e.g., silicon dioxide (SiO₂), silicon nitride (Si₃N₄), silicon oxynitride (SiON), silicon carbide (SiC), silicon carbon nitride (SiCN), silicon oxycarbon nitride (SiOCN), aluminum oxide (Al₂O₃), low-k dielectrics such as carbon-doped oxide (CDO) or porous silicon dioxide (SiOz), titanium dioxide (TiOz), tantalum oxide (TazOs)). Thus, in some embodiments, the release layer(s) may be made of one or more materials that include elements such as aluminum (Al), tungsten (W), copper (Cu), titanium (Ti), tantalum (Ta), silicon (Si), oxygen (O), nitrogen (N), hydrogen (H), and carbon (C), including, without limitation, any of the materials referenced above.

The flowchart then proceeds to block 704 to receive a second substrate with one or more adhesive areas, which may be referred to as the receiver substrate. In some embodiments, the receiver substrate may include a base substrate patterned with one or more adhesive areas on the surface, such as a layer of raised bonding structures or "mesas" over the base substrate. The receiver substrate may also optionally include a release layer over the base substrate (e.g., to enable the base substrate to be subsequently debonded after the transfer) and/or one or more additional buildup layers and/or IC components.

In some embodiments, the receiver substrate may be formed by receiving the base substrate, optionally forming a release layer over the base substrate, optionally forming additional buildup layers and/or IC components over the base substrate (e.g., over the optional release layer, if included), and forming the adhesive areas (e.g., bonding structures) on the surface of the receiver substrate (e.g., over the previously referenced layers, if included). In some embodiments, the base substrate and the optional release layer of the receiver may be made of any of the materials referenced above for the base substrate and the release layer of the donor, respectively.

In some embodiments, the adhesive areas may include mesa structures with similar footprints as the corresponding IC components to be transferred from the donor (although, in some cases, the mesas may be slightly larger or smaller than the IC components to accommodate alignment and manufacturing tolerances). The mesa structures may be made of varying materials depending on the type of bond and/or whether electrical connections are needed through the bond interface for the subsequently bonded IC components (e.g., dielectric material, metal, or both). For example, the mesa structures may include blanket dielectric structures with no conductive contacts (e.g., for dielectric-to-dielectric bonds), dielectric structures with conductive contacts (e.g., for hybrid dielectric and metal bonds), and/or conductive contacts by themselves (e.g., for metal-to-metal bonds). Thus, in some embodiments, the mesa structures may be made of one or more materials that include elements such as silicon (Si), oxygen (O), hydrogen (H), nitrogen (N), carbon @, aluminum (Al), tungsten (W), copper (Cu), titanium (Ti), tantalum (Ta), including, without limitation, inorganic dielectrics such as silicon dioxide (SiOz), silicon nitride (Si₃N₄), and/or silicon carbon nitride (SiCN), organic dielectrics such as photoresists and adhesives, and/or conductive materials such as metals and alloys (e.g., any of the foregoing metal elements and/or compounds/alloys thereof).

In various embodiments, however, any suitable technique(s) may be used to control the level of adhesion on different areas of the receiver substrate. For example, a variety of surface treatments (e.g., lithographically or additively manufactured) can be used to enhance and/or reduce adhesion in select areas of the receiver substrate, including, without limitation, modifying the surface topography (e.g., raised vs. recessed areas, smooth vs. rough areas), use of materials with high and/or low adhesion (e.g., forming layers with adhesive and non-adhesive materials in select areas), treatments using hydrophobic materials and/or self-assembled monolayers (SAMs), and/or surface activation techniques (e.g., plasma or wet activation), among other examples.

For example, the surface topography of the receiver substrate may be modified (e.g., using techniques such as deposition, lithography, etching, roughening) to form areas with different levels of adhesion, such as raised (e.g., adhesive) and recessed (e.g., non-adhesive) areas, smooth (e.g., adhesive) and rough (e.g., non-adhesive) areas, etc.

As another example, the surface of the receiver substrate may be patterned with materials having high and/or low adhesion in select areas. For example, a layer patterned with different areas of adhesive and non-adhesive materials may be formed on the receiver substrate. In some embodiments, the adhesive material may include silicon dioxide (SiOz) or silicon carbon nitride (SiCN) to promote strong oxide fusion bonds, silicon carbide (SiC) to provide lower thermal contact resistance compared to SiOz or SiCN, and/or metal to form electrical connections. Further, in some embodiments, the non-adhesive material may include silicon nitride (Si₃N₄) to form weak or no bonds.

As another example, treatments using hydrophobic materials and/or self-assembled monolayers (SAMs) may be used to enhance and/or reduce adhesion in select areas of the receiver substrate (e.g., using a SAM treatment to create monolayers with high and/or low adhesion in select areas). In some embodiments, the hydrophobic material may include a SAM material such as an alkyl or fluoroalkyl silane (e.g., ODS, FDTS), a thiol (e.g., hexadecane thiol), a phosphonic acid (e.g., octadecyl or perfluorooctane phosphonic acid), or an alkanoic acid (e.g., heptadecanoic acid). However, non-SAM based materials or films may also be used. In some embodiments, the hydrophobic material may include a thin polymer film such as a siloxane (e.g., PDMS and derivatives, HMDSO), a silazane (HMDS), a polyolefin (e.g., PP), or a fluorinated polymer (e.g., PTFE, PFPE, PFDA, C4F8 plasma polymerized films, etc.). Other hydrophobic materials may be used in other embodiments.

As another example, surface activation techniques may be used to enhance and/or reduce adhesion in select areas of the receiver substrate, including, without limitation, plasma or wet activation.

The flowchart then proceeds to block 706 to partially bond the donor substrate to the receiver substrate (e.g., face to face), such that one or more target IC components on the donor substrate are selectively bonded to the one or more adhesive areas on the receiver substrate. The donor and receiver substrates may be partially bonded using any suitable bonding techniques, including, without limitation, hybrid bonding, fusion bonding, and/or adhesive bonding.

The flowchart then proceeds to block 708 to release the target IC components from the donor substrate and separate the donor substrate from the receiver substrate. In this manner, when the donor and receiver substrates are separated, the target IC components are separated from the donor substrate and remain on the receiver substrate.

In some embodiments, the donor and receiver substates may be debonded/separated from each other by releasing, at least partially, the target IC components from the release layer of the donor substrate and then mechanically separating the donor and receiver substrates. For example, in some embodiments, the target IC components may be fully released from the donor substrate by selectively debonding them from the donor release layer using a laser (e.g., an IR or UV laser), or alternatively, the target IC components may be partially released from the donor substrate by weakening the donor release layer using a laser (e.g., an IR or UV laser). After fully or partially releasing the target IC components from the donor, the donor and receiver substrates are mechanically separated, and post separation, the target IC components remain bonded to the receiver and are no longer on the donor.

Alternatively, or additionally, the donor release layer and the receiver bonding structures may be formed with respective materials that have disparate bond strengths-such that the target IC components have a stronger bond to the receiver than the donor-thus causing the target IC components to debond from the donor and remain on the receiver when the donor and receiver are mechanically separated.

The flowchart then proceeds to block 710 to perform any remaining processing, such as dielectric filling and planarization, attaching additional IC dies or components (e.g., via selective transfers or pick-and-place assembly), forming interconnects (e.g., vias, traces), attaching a structural substrate, debonding the receiver base substrate (e.g., via the optional receiver release layer), and/or any other processing required for the finished product (e.g., an IC package, device, system, etc.).

The completed product may include a variety of components and circuitry (some of which may have been selectively transferred), including electrical components (e.g., electronic integrated circuits (EICs), processors, XPUs, controllers, memory), optical components (e.g., optical interfaces, photonic integrated circuits (PICs), optical connectors, fibers), and/or radio frequency (RF) or high-voltage components (e.g., high-voltage electrostatic discharge (ESD) devices, power amplifiers (PAs), low noise amplifiers (LNAs), voltage controlled oscillators (VCOs), surface acoustic wave (SAW) / bulk acoustic wave (BAW) devices or filters, bandpass filters (BPFs), intermediate-frequency (IF) amplifiers, frequency synthesizers, mixers, RF digital-to-analog converters (DACs), RF analog-to-digital converters (ADCs), thick gate oxide devices, Group III-V devices/chiplets, passive RF devices such as interconnects, antennas, and inductors).

Further, in some embodiments, the resulting IC package or product may be electrically coupled to a circuit board and/or incorporated into an electronic device or system (e.g., with other electronic components).

At this point, the flowchart may be complete. In some embodiments, however, the flowchart may restart and/or certain blocks may be repeated. For example, in some embodiments, the flowchart may restart at block 702 to continue performing selective transfers.

### Selective Transfer Of Optical And Opto-Electronic Components

Typical silicon photonics architectures may have some components fabricated in situ (e.g., waveguides, ring resonators), other components assembled through hybrid assembly techniques (e.g., by transferring a blank semiconductor component and then processing it in situ, such as for certain laser fabrication techniques), and the remaining components assembled through standard assembly techniques (e.g., pick-and-place assembly for electronic integrated circuit (EIC) components such as drivers and transimpedance amplifiers (TIAs)). While this combination attempts to utilize the capabilities of each individual technique to hit performance and cost targets, there are various drawbacks. Other embodiments are also possible, for example all the components may be fabricated monolithically on the same substrate (e.g., using a combined CMOS and optical/optoelectronic manufacturing process).

For example, in-situ manufacturing techniques typically involve a full transfer or growth of an active layer (e.g., gallium nitride (GaN) or indium phosphide (InP)) followed by etching out the unneeded portions. This approach is cost inefficient since a big portion of the transferred or grown material is effectively etched away.

Hybrid manufacturing techniques typically involve transferring blocks of active layers (e.g., GaN or InP materials) and then processing them in situ. While this approach is more cost efficient than in-situ techniques with full layer transfers, the manufacturing is not well parallelized since most of the wafer is effectively masked while the transferred components are being fabricated.

Pick-and-place assembly techniques typically involve mechanically transferring fabricated devices (e.g., arrays of optoelectronic components) to a photonics substrate. In this manner, all components can be manufactured in parallel on their respective ideal substrates (e.g., logic/Si, GaN, InP, etc.), and the finished components can then be attached to the final photonics substrate. However, standard assembly techniques have limitations on the size and thickness of the respective components, which limits the applicability of this approach to relatively large components or to transferring larger components then etching them to reduce their size which limits the efficiency and increases the cost. Further, die handling can cause edge dislocations, which may render the substrate materials (e.g., InP) inefficient and susceptible to defects.

Accordingly, this disclosure presents techniques for parallel transfer of optical and opto-electronic components using selective transfer technology, along with devices and systems formed using the same. In particular, selective transfer technology (e.g., as described above in connection with FIGS. 1-7) is used to transfer a variety of optical and opto-electronic components from their original substrates to a photonics substrate.

The described solution provides various advantages. For example, this solution enables parallel manufacturing and transfer of the respective components of optical devices, which increases manufacturing speed and reduces costs compared to in-situ fabrication techniques and standard pick-and-place assembly. This solution also enables all components to be manufactured on their respective substrates with significantly less wasted processing area compared to hybrid manufacturing techniques. Further, this solution enables direct assembly of all components, which simplifies the manufacturing flow, reduces costs, and improves performance.

This solution also enables granular integration of different optical and opto-electronic components with high placement accuracy and very few limitations on the area of transferred components. As a result, optical and electronic components can be placed very close together, which results in much lower parasitics and higher energy efficiency.

This solution also enables integration of components from incompatible process technologies. For example, photonic integrated circuits (PICs) include a variety of components fabricated using different process technologies, some of which may be incompatible with each other. In particular, silicon/silicon dioxide (Si/SiO₂) waveguide, germanium (Ge) photodiode, and gallium nitride (GaN) transistor technologies incorporate high-temperature fabrication steps, which may not be compatible with process technologies for the ring modulator and laser. This solution enables all of those components to be fabricated using separate and distinct process technologies, in different fabs, and eventually, assembled using selective transfers.

This solution also enables the use of novel base substrates for optical devices. In particular, since typical in-situ manufacturing steps can be completely replaced with selective transfers, this solution provides the flexibility to use base substrates made of materials other than silicon, such as glass substrates, silicon-on-insulator (SOI) substrates, or silicon carbide (SiC) substrates, among other examples. In some cases, for example, a glass substrate may be used for lower loss, improved electrical losses, and/or operating at different frequencies. Substrates in panel formats may be used to enable wafer-scale systems. Further, in some cases, substrates and/or components may be selectively transferred directly on top of a silicon substrate within a CMOS fabrication process flow.

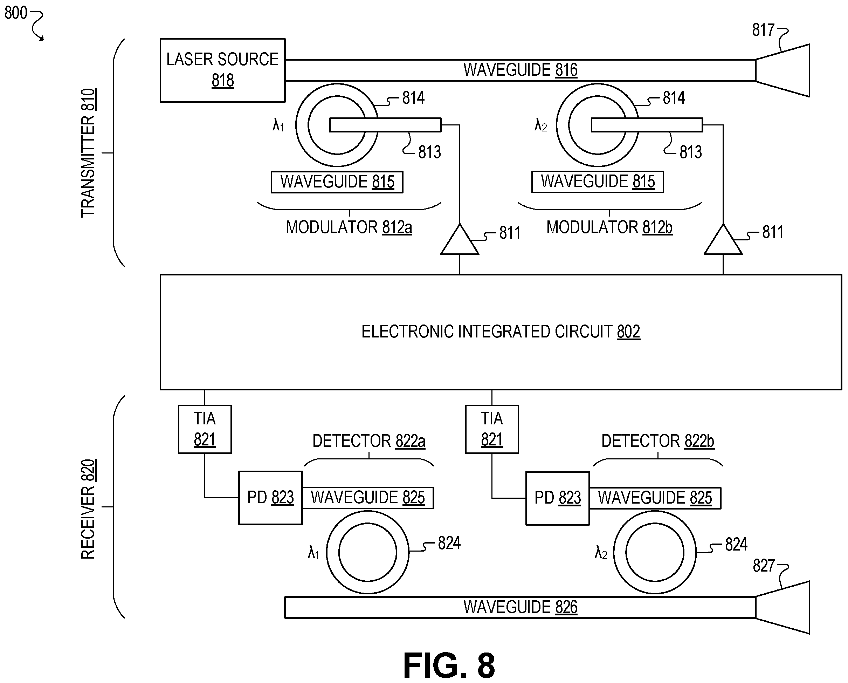

**FIG. 8** illustrates an example embodiment of an optical transceiver 800. In various embodiments, some or all of the components of optical transceiver 800 may be assembled using the selective transfer technology described throughout this disclosure (e.g., in connection with FIGS. 1-7 and 9-12).

In the illustrated embodiment, optical transceiver 800 includes an electronic integrated circuit (EIC) 802, a transmitter 810, and a receiver 820.

The EIC 802 includes various high-speed electronics and/or control electronics (e.g., in-plane or stacked), such as carrier phase recovery (CPR), clock and data recovery (CDR), error correction, serializers/deserializers (serdes), equalizers, samplers, mixers, amplifiers, temperature control (e.g., heaters), analog-to-digital converters (ADC) and digital-to-analog converters (DAC), control and switching, controllers/compute engines, power delivery, and/or power conversion. The EIC 802 typically also includes drivers 811 and transimpedance amplifiers (TIAs) 821, but in the illustrated embodiment, the drivers 811 and TIAs 821 are disaggregated from the EIC 802 (e.g., implemented on separate IC dies) and placed near the modulators 812a-b and photodetectors (PDs) 823, respectively, to improve performance, as described below.

The transmitter 810 includes a laser source 818, a waveguide 816 to guide light from the laser source 818, an optical coupler 817 to couple the waveguide 816 to another optical component such as a fiber (not shown), multiple modulators 812a-b to modulate different wavelengths of light (λ₁, λ₂) on the transmitter waveguide 816, and multiple drivers 811 to control the respective modulators 812a-b. In the illustrated embodiment, ring resonator modulators 812a-b are used. Each modulator 812a-b includes an electrode 813, a ring resonator 814, and a waveguide 815. When the corresponding driver 811 applies a voltage to the ring resonator 814 via the electrode 813, light of a particular wavelength (e.g., λ₁ or λ₂) on the transmitter waveguide 816 is absorbed by the ring resonator 814 and output to the modulator waveguide 815, thus effectively filtering the particular wavelength of light from the transmitter waveguide 816. In this manner, multiple wavelengths of light can be multiplexed on the transmitter waveguide 816 using the respective drivers 811 and modulators 812a-b, which is referred to as wavelength-division multiplexing (WDM). Other types of modulators are also possible, such as Mach-Zehnder modulators and variants thereof.

The receiver 820 includes a waveguide 826 to guide light received from another component (not shown) via an optical coupler 827, multiple detectors 822a-b to detect different wavelengths of light (λ₁, λ₂) on the receiver waveguide 826, and multiple photodetectors (PDs) 823 and transimpedance amplifiers (TIAs) 821 to convert the detected light waves into electrical signals and amplify them. Each detector 822a-b includes a ring resonator 824 and a waveguide 825. When light of a particular wavelength (e.g., λ₁ or λ₂) is received on the receiver waveguide 826, those light waves are transmitted by the corresponding ring resonator 824 to the detector waveguide 825, and then passed as input to the PD 823. The PD 823 converts the light waves (e.g., optical signals) into electric current, and the TIA 821 converts the current into corresponding voltage (e.g., current-to-voltage conversion), which is then passed to the EIC 802 to generate/output an electrical (e.g., digital) signal based on the voltage. In this manner, multiple wavelengths of light can be received on the receiver waveguide 826, demultiplexed, and then converted into corresponding electrical signals (e.g., using the respective TIAs 821, PDs 823, and detectors 822a-b). For simplicity, not all components of an optical transceiver 800 are shown in the illustrated example (e.g., there may be heaters and corresponding control circuitry to control the temperature of the different optical/opto-electronic components, among other components).

In the illustrated embodiment, certain components that are typically integrated within the EIC 802 are disaggregated or disintegrated from the EIC 802 to improve performance. For example, the TIAs 821 are disaggregated from the EIC 802 and placed closer to the PDs 823 to reduce parasitics, maximize receiver sensitivity, and provide higher energy efficiency. Similarly, the drivers 811 are disaggregated from the EIC 802-enabling them to be implemented using a different (e.g., optimized) semiconductor process-and placed closer to the respective modulators 812a-b. In some embodiments, these disaggregated components may be assembled in the optical transceiver 800 using selective transfer technology, which enables the components to be fabricated in parallel on optimal substrate materials using optimal process technologies, and then selectively transferred to optimal locations in the optical transceiver circuit 800, without the downsides of other techniques (e.g., constraints on size, area, and thickness for components assembled using pick-and-place techniques).

In some embodiments, other components of the optical transceiver 800 may similarly be assembled using selective transfer technology, including the EIC 802, waveguides 815, 816, 825, 826, ring resonators 814, 824, electrodes 813, PDs 823, and laser source 818, among other examples.

It should be appreciated that the illustrated embodiment of optical transceiver 800 is merely presented as an example and numerous other variations are also possible. For example, the optical transceiver 800 may include any number of EICs 802, transmitter units 810, receiver units 820, waveguides 816, 826, modulators 812, detectors 822, drivers 811, TIAs 821, PDs 823, and so forth. The optical transceiver 800 may include other components not shown, and/or certain components may be omitted, combined, separated, and/or rearranged.

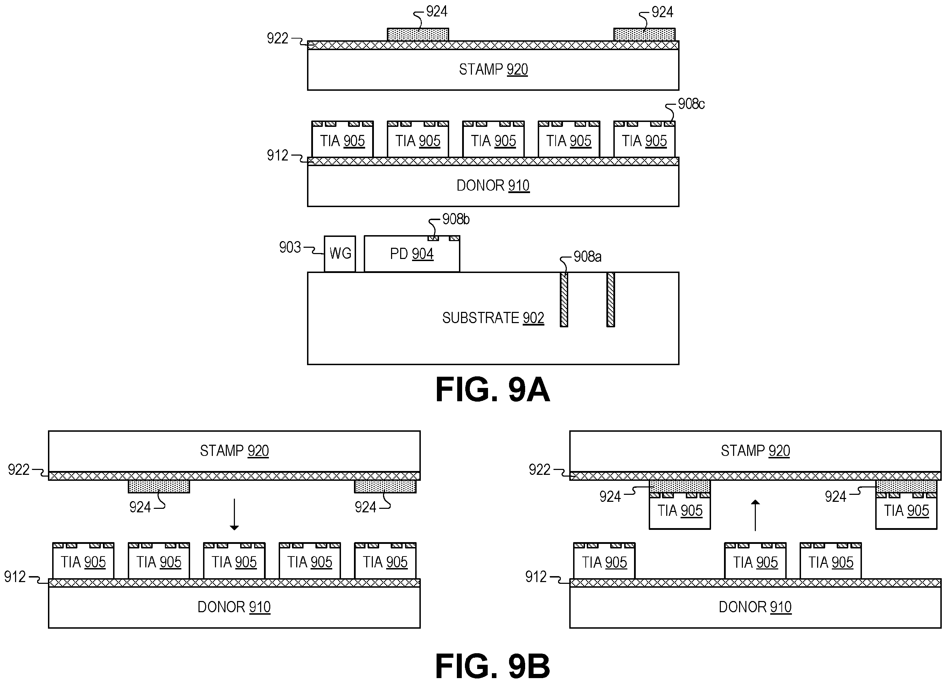

FIGS. 9A-F illustrate an example process flow for forming an optical transceiver 900 using selective transfer technology. In the illustrated example, a transimpedance amplifier (TIA) 905 is laterally integrated into the optical transceiver 900 using selective transfer technology. However, the same approach can also be used to integrate other electrical and/or optical components into the optical transceiver 900 (e.g., laterally/in plane or stacked).

Selective transfer technology, in combination with quasi-monolithic chip (QMC) building blocks, can be used to transfer electrical components very close to optical components to improve overall system performance. In particular, certain components that are typically integrated within the electronic integrated circuit (EIC) 906 may be disaggregated or disintegrated from the EIC 906 (e.g., such that the EIC and the disaggregated components are implemented on separate IC dies) to enable them to be placed closer to corresponding optical components. As an example, the TIA circuit 905 can be disaggregated from the EIC 906 and fabricated as a standalone chiplet, and the TIA chiplet 905 can be selectively transferred near the photodetector (PD) 904 on a photonic substrate 902, which enables a very close connection between the TIA 905 and the PD 904 to maximize receiver sensitivity. Similarly, a driver circuit could be disaggregated from the EIC 906 and selectively transferred near an optical modulator.

In this manner, the electrical components can be fabricated in parallel on optimal substrate materials using optimal process technologies, and then selectively transferred to optimal locations in the photonic substrate 902, without the downsides of other techniques (e.g., incompatible process technologies, dimensional constraints on pick-and-place assembly). In some embodiments, for example, certain high-speed electronics may be implemented using Group III-V semiconductor devices, such as GaN transistors, which are well-suited for high-voltage and high-frequency driver electronics and low-noise amplifiers due to their wide bandgap and high mobility channel.

An example process flow is shown in FIGS. 9A-F. In FIG. 9A, three substrates are fabricated in parallel: a photonic substrate 902, a donor substrate 910, and a stamp substrate 920. The photonic substrate 902 may be fabricated using any suitable techniques, including selective transfer techniques, monolithic fabrication, and/or pick-and-place assembly. In the illustrated embodiment, the photonic substrate 902 includes through-silicon vias (TSVs) 908a, an optical waveguide 903, and a photodetector 904 (with pads 908b). In parallel, the sensitive electrical components (e.g., the TIA 905 for the PD 904) are fabricated on a separate substrate, thinned, and then transferred to the donor substrate 910 and singulated over the release layer 912. The stamp substrate 920 is fabricated with raised mesas 924 over a release layer 922 to enable placing the TIA dies 905 in the target areas on the photonic substrate 902. In some embodiments, the raised mesas 924 may be raised dielectric and/or metal structures with similar footprints as the corresponding components to be selectively transferred (e.g., TIAs 905, PDs 904, optical waveguides, ring resonators, drivers, EICs, etc.).

In FIG. 9B, some of the TIAs 905 on the donor substrate 910 are selectively transferred to the stamp substrate 920.

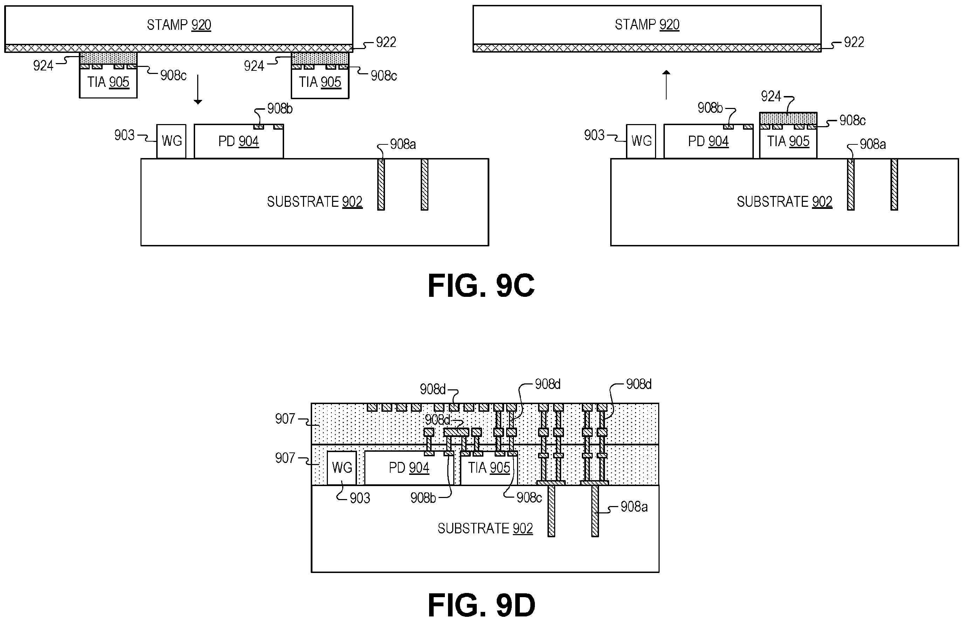

In FIG. 9C, the TIAs 905 on the stamp substrate 920 are selectively transferred to the photonic substrate 902 near corresponding PDs 904 (only one of the transferred TIAs 905 and corresponding PDs 904 are shown on the photonics substrate 902). Moreover, the mesas 924 on the stamp 920 are transferred with the TIAs 905 and remain above the TIAs 905 after the transfer. As a result, the mesas 924 are subsequently removed from the TIAs 905 (e.g., via etching) to expose the pads 908c on the TIAs 905 before further processing (as shown in FIG. 9D).

In FIG. 9D, interconnects 908d are formed over the PD 904 and the TIA 905 within dielectric layers 907. The interconnects 908d include short lateral routing between the PD 904 and the TIA 905 to enable low parasitics, along with vertical connections to hybrid bonding pads (e.g., for attaching the EIC 906).

Other interconnects may also be formed on the substrate 902 to enable additional electrical connections. In some embodiments, for example, the photonic IC may also function as an electrical interposer to enable electrical connections between multiple top chiplets, and thus an interconnect may be formed for the interposer capability. Further, the interconnects may be fabricated monolithically as shown, or other chiplets that can provide the electrical connection functionality may be fabricated and then assembled and/or selectively transferred.

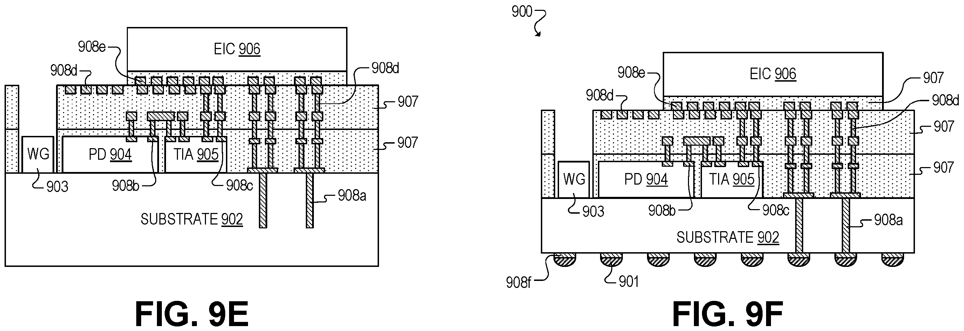

In FIG. 9E, the inter-layer dielectric 907 above the waveguide 903 is etched out to expose the waveguide 903. For example, depending on the specific architecture, some components may be sensitive to the surrounding dielectric 907 (e.g., low loss waveguides 903) or may need to be exposed for other reasons (e.g., attaching couplers to optical fibers). In those cases, a deep etch may be performed to etch out the ILD dielectric 907 and expose those areas. In some embodiments, this etch process may be included in the fabrication flow by coating a thin etch stop or sacrificial layer (e.g., aluminum oxide (AlOₓ)) over the optical components-this layer works as an etch stop during an oxide etch and can be removed afterwards with a different etch process.

Further, the EIC 906 may be attached to the top surface using standard assembly techniques, such as pick-and-place assembly with hybrid bonding (e.g., via the respective hybrid bonding pads 908d,e and dielectric layers 907) or with solder assembly if the density and added parasitics are acceptable. Alternatively, in some embodiments, highly disaggregated EIC chiplets may be attached using selective transfer techniques with on-chip routing to enable electrical connectivity.

In FIG. 9F, the bottom side of the photonic substrate 902 is thinned to expose the TSVs 908a, and solder bumps 901 are formed on pads 908f on the bottom side to enable flip chip assembly with TSVs 908a. In other embodiments, any suitable interconnect or packaging technology may be used, such as wirebonding or TSV-less attach with solder connection on the top side. The completed optical transceiver 900 can then be attached to an IC package, printed circuit board (PCB), or another device/substrate depending on the requirements.

It should be appreciated that the illustrated process flow for forming an optical transceiver 900 using selective transfer technology is merely presented as an example and many other process variations and architectures are also possible, including those described in connection with other figures. Moreover, other electrical and/or optical components can be selectively transferred to the photonic substrate 902 in a similar manner, including EICs, drivers, photodetectors 904, optical waveguides, mirrors, ring resonators, modulators, detectors, diffraction grating, isolation, and/or anti-reflection structures, heater elements, and so forth.

Further, the selective transfers may be performed using any of the selective transfer techniques described throughout this disclosure (e.g., in connection with FIGS. 1-7). For example, selective transfers of the same type of dies may be performed using the process flow shown in FIGS. 1A-I. Alternatively, or additionally, selective transfers of different types of dies/components can be performed using intermediate donor/receiver substrates as described in connection with FIGS. 4A-C. For example, multiple types of electronic and/or optical components (e.g., TIAs, PDs, drivers, etc.) may be transferred to the stamp substrate 920 from different donor substrates 910.

In some embodiments, for example, the donor wafer 910 may include a variety of IC components, such as TIA ICs, driver ICs, telemetry ICs, and so forth. Moreover, during the stamp 920 bond/debond transfer steps, the stamp 920 may pick up and selectively transfer the TIA ICs to the photonic wafer 902 first, followed by the driver ICs, then the telemetry ICs, etc. Alternatively, or additionally, there may be multiple donor wafers 910 that each contain separate intellectual property (IP) blocks, such as a donor 910 with TIA ICs, a donor 910 with driver ICs, etc. During the stamp 920 bond/debond selective transfer steps, the stamp 920 may first pick up and transfer TIAs from the TIA donor wafer 910 to the photonic wafer 902, then transfer driver ICs from the driver donor wafer 910, etc. In the case of stamp 920 selective transfers, there may not be corresponding lower mesas on the transferred components, but if other selective transfer techniques are used, there may be corresponding mesas.

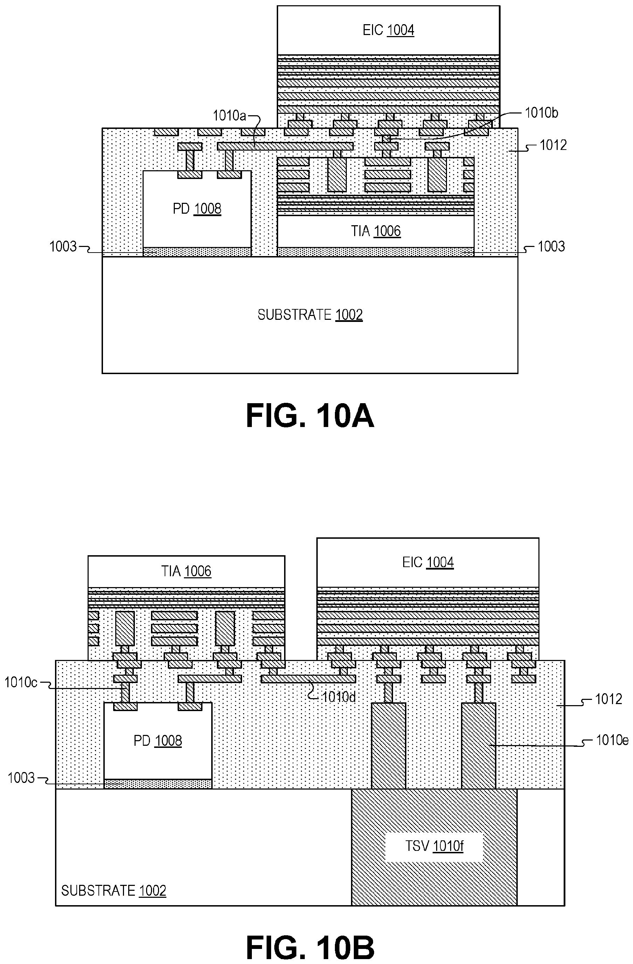

FIGS. 10A-E illustrate example configurations of electrical and optical components integrated using selective transfer technology. In particular, an electronic integrated circuit (EIC) 1004, a transimpedance amplifier (TIA) 1006, and a photodetector (PD) 1008 are integrated in various configurations using selective transfer technology.

In FIG. 10A, the TIA circuit 1006 is disaggregated from the EIC 1004 and associated logic, which enables low-parasitics routing 1010a between the TIA 1006 and the PD 1008, along with optimized process technology for fabrication of the TIA 1007. For example, the PD 1008 and the TIA 1006 are selectively transferred to the substrate 1002 next to each other (e.g., in the same layer) on raised dielectric mesas 1003. Moreover, an interconnect 1010 is formed in the inter-layer dielectric (ILD) material 1012 over the PD 1008 and the TIA 1006, with lateral routing 1010a between the PD 1008 and the TIA 1006, and vertical routing 1010b between the TIA 1006 and the EIC 1004 (with the EIC 1004 above the TIA 1006). In the illustrated embodiment, the EIC 1004 is hybrid bonded above the TIA 1006, but in other embodiments, the EIC 1004 may be selectively transferred above the TIA 1006.

In FIG. 10B, the TIA circuit 1006 is disaggregated from the EIC 1004 and placed above the PD 1008 and lateral to the EIC 1004, with vertical routing 1010c between the TIA 1006 and the PD 1008, lateral routing 1010d between the TIA 1006 and the EIC 1004, and vertical routing 1010e,f between the EIC 1004 and the bottom of the substrate 1002 (e.g., with through-dielectric vias 1010e in the ILD 1012 and through-silicon vias (TSVs) 1010f in the substrate 1002). The PD 1008 is selectively transferred to the substrate 1002 on a raised dielectric mesa 1003, the TIA 1006 is hybrid bonded above the PD 1008, and the EIC 1004 is hybrid bonded next to the TIA 1006.

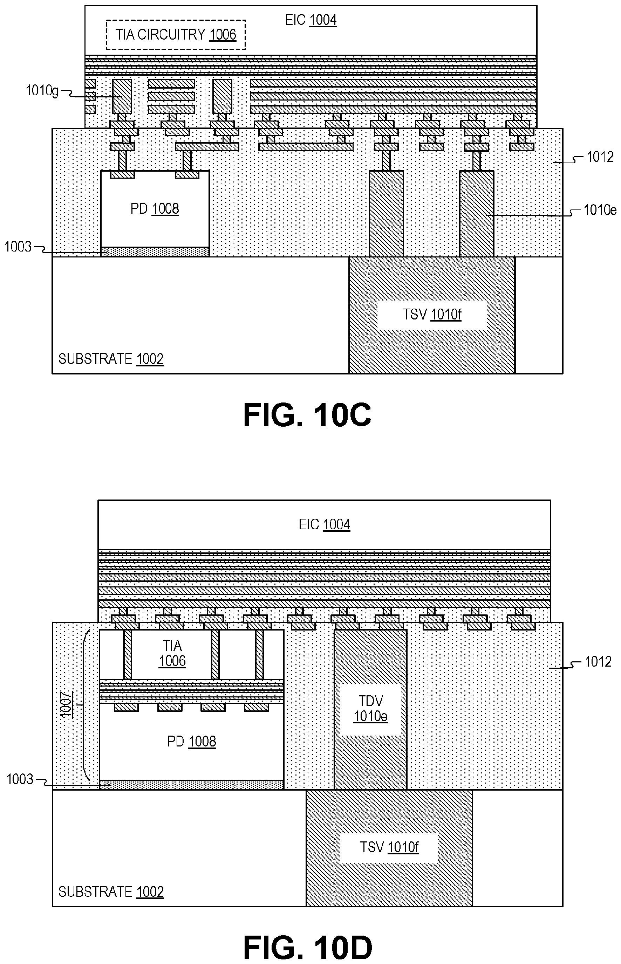

In FIG. 10C, the TIA circuitry 1006 is integrated as part of the EIC chip 1004, with vertical routing between the TIA circuitry 1006 and the PD 1008 using express vias or super vias 1010g to minimize routing parasitics, and vertical routing to the bottom of the substrate 1002 using TDVs 1010e and TSVs 101 0f. The PD 1008 is selectively transferred to the substrate 1002 on a raised dielectric mesa 1003, and the EIC 1004 (with integrated TIA circuitry 1006) is hybrid bonded above the PD 1008.

In FIG. 10D, the disaggregated TIA circuit 1006 is integrated with the PD 1008 prior to a selective transfer. The integrated TIA/PD 1007 is then selectively transferred to the substrate 1002 on a raised dielectric mesa 1003. This enables the lowest parasitics integration and minimizes the routing needed on the PD circuit 1008. The EIC 1004 is hybrid bonded above the integrated TIA/PD 1007, with vertical routing 1010e,f between the EIC 1004 and the bottom of the substrate 1002 (e.g., with through-dielectric vias 1010e in the ILD 1012 and through-silicon vias (TSVs) 1010f in the substrate 1002).

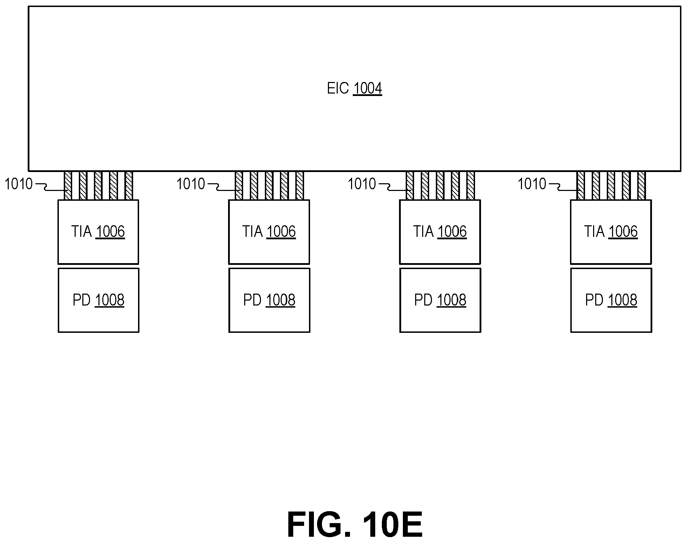

In FIG. 10E, a plan view is shown of an EIC chip 1004 with routing 1010 to disaggregated TIAs 1006 and associated PDs 1008. In some embodiments, the EIC 1004 may itself be disaggregated to enable optical routing and/or placement of taller components within the EIC controller.

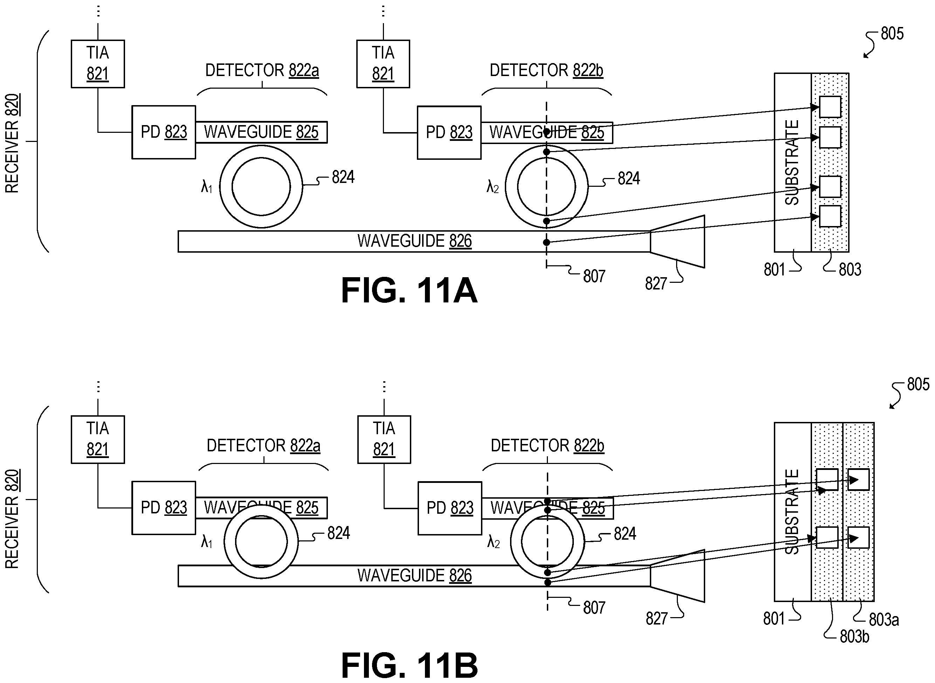

FIGS. 11A-B illustrate various arrangements of selectively-transferred optical components. In particular, FIGS. 11A and 11B show single-layer and multi-layer arrangements of selectively transferred components, respectively, in the receiver 820 of optical transceiver 800.

For example, selective transfer technology can be used to transfer optical components, such as photodetectors, optical waveguides, mirrors, ring resonators, modulators, detectors, diffraction grating, isolation, and/or anti-reflection structures, and heater elements, among other examples. The respective components can be selectively transferred in plane (e.g., within a single layer) to maintain the same architecture capability, or they can be stacked across multiple layers to further reduce the system size and/or reduce losses.

Examples of a micro-ring resonator device transferred into a single layer and across multiple layers are respectively shown in FIGS. 11A and 11B. In these examples, the micro-ring resonator device includes the ring resonator 824 and the waveguides 825, 826 from the receiver 820 of optical transceiver 800.

In FIG. 11A, the waveguides 825, 826 and ring resonator 824 are transferred in plane, or within the same layer 803, as shown by the cross-section view 805. In particular, the cross-section view 805 depicts a cross section of the referenced components 824, 825, 826 across a cutting plane 807 of the receiver 820. Moreover, the cross-section view 805 has been rotated 90 degrees to match the orientation of components in the plan view of the receiver 820. As shown by the cross-section view 805, the waveguides 825, 826 and ring resonator 824 are adjacent to each other within the same dielectric layer 803 on a carrier substrate 801.

In FIG. 11B, the waveguides 825, 826 and ring resonator 824 are stacked across multiple dielectric layers 803a-b on the carrier substrate 801, as shown by the cross-section view 805 along the cutting plane 807. For example, the waveguides 825, 826 are transferred next to each other in a first layer 803a, and the ring resonator 824 is transferred above the waveguides 825, 826 in a second layer 803b.

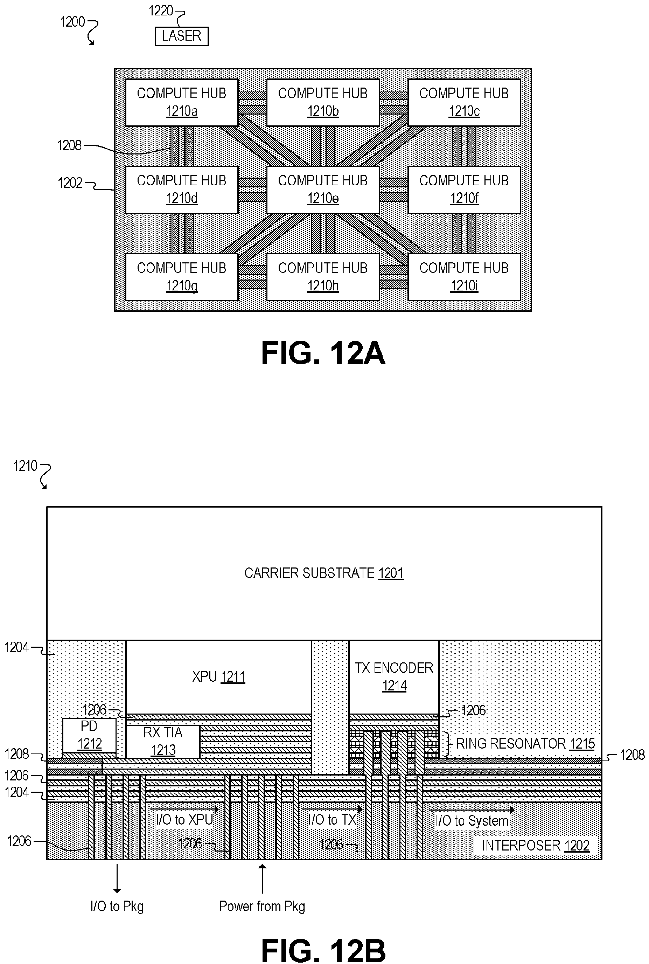

FIGS. 12A-B illustrate an example embodiment of a compute platform 1200 with multiple compute hubs 1210a-i connected over an optical interconnect 1208. As described below, compute platform 1200 includes a variety of selectively transferred optical and electrical components, including logic (e.g., CMOS) devices such as XPUs. A plan view of the compute platform 1200 is shown in FIG. 12A, and a cross-section of one of the compute hubs 1210 on the compute platform 1200 is shown in FIG. 12B.

As shown in FIG. 12A, compute platform 1200 is a large-scale compute platform with multiple compute hubs 1210a-i interconnected by a waveguide array 1208 on an interposer 1202, with an off-system laser source 1220 (e.g., connected via glass fibers). In other embodiments, however, the laser source 1220 may be integrated on the system 1200.

As shown in FIG. 12B, each compute hub 1210 includes one or more XPUs 1211 with a variety of integrated components for optical communication, including integrated photodiodes (PDs) 1212, receive-side (Rx) transimpedance amplifiers (TIAs) 1213, high-speed transmit-side (Tx) data encoders 1214 coupled with embedded ring resonators 1215, and optical waveguides 1208. These various optical and opto-electrical components (along with other components not shown, such as EICs, drivers, etc.) collectively form an optical transceiver, which is used to send and/or receive optical signals (e.g., data packets) on behalf of and among the XPU(s) 1211 and memory banks (not shown) on the respective compute hubs 1210. In various embodiments, the XPU(s) 1211 may include any type of processing unit, such as a central processing unit (CPU), a graphics processing unit, an application-specific integrated circuit (ASIC), a field-programmable gate array (FPGA), and so forth.

These various components are integrated on an interposer 1202 with a waveguide network 1208 for optical input/output (I/O) among the compute hubs 1210a-i, along with an electrical interconnect 1206 for power (e.g., from the IC package (not shown)) and I/O (e.g., I/O among components within each compute hub 1210a-i, I/O among the compute hubs 1210a-i or other components in the system 1200, and I/O among other components in the same IC package). The compute platform 1200 also includes inter-layer dielectric (ILD) materials 1206 separating the respective components and a carrier substrate 1201 for structural support (e.g., a silicon thermal handle carrier).

In the illustrated embodiment, selective transfer technology is used to interconnect both compute and photonic devices across an interposer 1202, such as a passive glass or silicon interposer or an active interposer. The waveguide network 1208 may be fabricated directly on top of the interposer 1202 or fabricated elsewhere and selectively transferred to the interposer 1202. Additionally, sub-components can be pre-made using the same approach or transferred sequentially to create a high-speed transmission (Tx) data encoding system 1214 with ring resonators 1215 within the footprint and coupled to the waveguides 1208 vertically across the network to maintain a tight spacing to the underlying waveguides 1208. This has the advantage of allowing thermal control with good isolation. A mixed fusion and hybrid bonded interconnect 1206 is used to maintain interconnection to a nearby XPU 1211 and/or memory solution as well as power from the package. Additionally, discrete photodiodes (PDs) 1212 may be selectively transferred over the waveguide array 1208 and evanescent coupling (among other approaches) may be utilized to maximize the current output. In some embodiments, the transimpedance amplifier (TIA) 1213 may be fabricated or selectively transferred over the photodiode layer (not shown) or situated at a tight spacing nearby such that vertical interconnects (e.g., TSVs) can be employed to allow direct vertical electrical coupling to the XPU 1211 (e.g., with a 3D interconnect). This system architecture allows for off-package I/O as well as XPU-to-XPU or memory hub interconnection with high data rates, which is crucial for extreme lateral system scaling. In some embodiments, electrical connections may be formed between the different top chiplets using monolithic interconnects or using assembled interconnect chiplets.

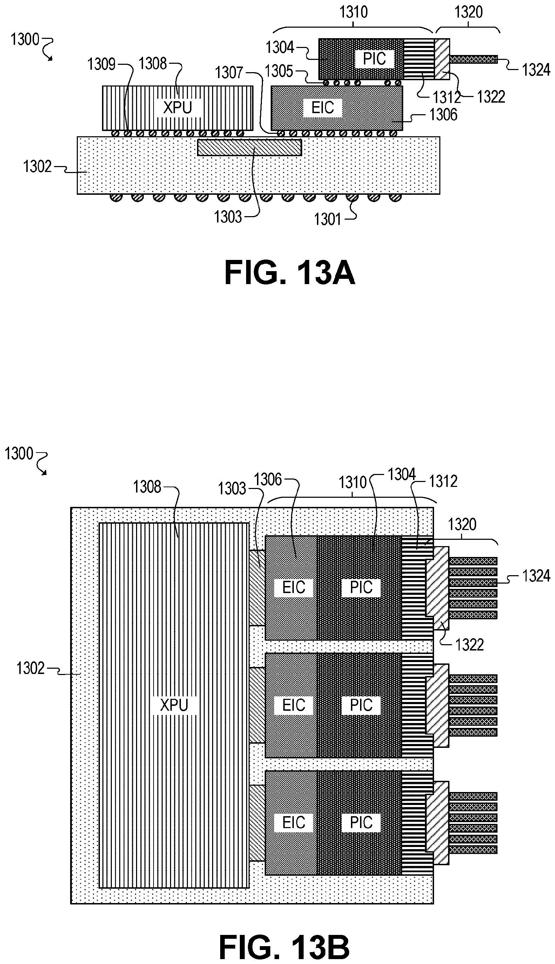

FIGS. 13A-B illustrate an example embodiment of an optical package 1300 in accordance with certain embodiments. In particular, cross-section and plan views of optical package 1300 are respectively shown in FIGS. 13A and 13B. In some embodiments, one or more components of optical package 1300 may be selectively transferred as described throughout this disclosure. Further, in some embodiments, certain components of the EICs 1306 and/or PICs 1304 may be disaggregated into separate chiplets or components and selectively transferred near each other to improve performance.

In the illustrated embodiment, the optical package 1300 includes an XPU 1308 and multiple optical interfaces (e.g., optical transceivers) 1310 on a package substrate 1302, along with optical cables 1320 plugged into the respective optical interfaces 1310.

Each optical interface 1310 includes an optical coupler 1312, a photonic integrated circuit (PIC) 1304, and an electronic integrated circuit (EIC) 1306. The EICs 1306 are attached to the top surface of the package substrate 1302, the PICs 1304 are attached to the top surface of corresponding EICs 1306, and the optical couplers 1312 are attached to the side/edge of corresponding PICs 1304.

The EICs 1306 are used to control the PICs 1304 and output digital signals based on optical signals received by the PICs 1304. In some embodiments, the EICs 1306 may receive and output analog and digital input and output signals. The EICs 1306 may contain digital, analog, and/or telemetry (e.g., performance monitoring) circuitry to perform control functions and signals processing, including components and circuitry such as drivers, transimpedance amplifiers (TIA), carrier phase recovery (CPR), clock and data recovery (CDR), error correction, serializers/deserializers (serdes), equalizers, samplers, mixers, amplifiers, temperature control (e.g., heaters), analog-to-digital converters (ADC) and digital-to-analog converters (DAC), control and switching, controllers/compute engines, power delivery, power conversion, and so forth. The EICs 1306 are electrically coupled to the package substrate 1302 via conductive contacts 1307 (e.g., bumps/micro-bumps), and the EICs 1306 are further electrically coupled to the XPU 1308 via the bridges 1303 embedded in the substrate 1302.

The PICs 1304 are used to send and/or receive optical signals via fiber arrays 1324 (e.g., on behalf of the XPU 1308). Each PIC 1304 includes components and circuitry for sending and receiving optical signals, such as laser diodes (LD) / modulators (LD-MOD) (e.g., for transmitting optical signals), photodiodes (PD) (e.g., for receiving optical signals), optical waveguides, optical couplers, collimation/refocusing lenses, reflection mirrors, and so forth. Each PIC 1304 is controlled by an associated EIC 1306 and is electrically coupled to the top surface of the EIC 1306 via conductive contacts 1305 (e.g., bumps/micro-bumps).

An optical coupler 1312 is also attached to each PIC 1304. The optical coupler 1312, which may also be referred to as an optical interposer, is used to optically couple, or route optical signals (e.g., light) between, the PIC 1304 and another optical component, such as an optical cable 1320. In some embodiments, the optical coupler 1312 may include an interface attached to the PIC 1304, an interface to mate with an optical ferrule 1322 on an optical cable 1320, and waveguides to route optical signals between the respective interfaces. The optical coupler 1312 may optionally include various other optical and/or electrical routing features, such as through-glass vias, reflection mirrors, and so forth.

Each optical cable 1320 includes an optical ferrule 1322 attached to a bundle of optical (e.g., glass) fibers 1324, which may be referred to as a fiber array or fiber array unit (FAU). The optical ferrule 1322 may be used to optically couple, or route optical signals between, the fiber array 1324 and an optical coupler 1312. In some embodiments, the optical ferrule 1322 may include an interface attached to the fiber array 1324 (e.g., holes in the ferrule 1322 in which the fibers 1324 are inserted), an interface to mate with an optical coupler 1312, and waveguides to route optical signals between the respective interfaces.

In some embodiments, for example, the optical coupler 1312 and the optical ferrule 1322 may include complementary pluggable interfaces that are designed to mate. For example, the optical coupler 1312 may include an optical socket and the optical ferrule 1322 may include a corresponding optical plug designed to mate with the optical socket (or vice versa). In this manner, each PIC 1304 is optically coupled to an associated fiber array 1324 via the mated optical coupler 1312 and optical ferrule 1322.

Further, in some embodiments, the optical coupler 1312 and optical ferrule 1322 may include complementary mating and alignment features (e.g., mating protrusions and receptacles, pins and pin holes, grooves) to ensure they mate with each other with the requisite degree of alignment, as the waveguides in the ferrule 1322 must be precisely aligned with the waveguides in the optical coupler 1312. For example, when the optical ferrule 1322 is plugged into to the optical coupler 1312, their respective mating and alignment features engage, which causes the waveguides in the ferrule 1322 to precisely align with the waveguides in the optical coupler 1312. In this manner, the PIC 1304 is optically coupled to the fiber array 1324 via the mated optical coupler 1312 and ferrule 1322, which enables the PIC 1304 to send and receive optical signals via the fiber array 1324.

In some embodiments, the optical coupler 1312 and/or optical ferrule 1322 may be made of glass, and their respective features (e.g., interfaces, mating/alignment features, waveguides) may be patterned in the glass (e.g., using laser etching techniques).

The fiber array 1324 may be used to send and receive optical signals to and from other components (not shown). For example, the other end of the fiber array 1324 may be optically coupled to other components (not shown), such as other computing components that are part of the same device or system as optical package 1300 (e.g., processors, XPUs, network interface controllers (NICs), storage, memory, I/O devices, other integrated circuits), an external device or system, a switch, another optical connector (e.g., a connector similar to optical coupler 1312 and/or optical ferrule 1322, a standard optical connector such as a mechanical transfer (MT) or multi-fiber push on (MPO) connector), a fiber cable, and so forth.

The XPU 1308 is attached to the top surface of the package substrate 1302. Moreover, the XPU 1308 is electrically coupled to the package substrate 1302 via conductive contacts 1309 (e.g., bumps/micro-bumps), which serve as the first level interconnect (FLI) for the XPU 1308. The XPU 1308 is also electrically coupled to the EICs 1306 via bridges 1303 embedded in the substrate 1302 (e.g., embedded multi-die interconnect bridges (EMIB)). In this manner, the XPU 1308 can use the EICs 1306 to communicate over the respective optical interfaces 1310.

The XPU 1308 may include any type or combination of integrated circuitry that uses the optical interfaces 1310 for optical communication. For example, the XPU 1308 may include any type or combination of processing units or other computing components, including, but not limited to, microcontrollers, microprocessors, processor cores, central processing units (CPUs), graphics processing units (GPUs), vision processing units (VPUs), tensor processing units (TPUs), application-specific integrated circuits (ASICs), field-programmable gate arrays (FPGAs), input/output (I/O) controllers and devices, switches, network interface controllers (NICs), persistent storage devices, and memory.

The package substrate 1302 includes conductive contacts 1301 (e.g., balls, pads) on the bottom surface, which serve as the second level interconnect (SLI) to a next-level component, such as a printed circuit board (e.g., a motherboard) and/or another integrated circuit package (not shown). The package substrate 1302 also includes conductive traces (not shown) patterned in the substrate to provide power and input/output (I/O) to the respective components in package 1300 (e.g., XPU 1308, EICs 1306, PICs 1304).

In some embodiments, the optical package 1300 may be part of an electronic device or system, such as a mobile device, a wearable device, a computer, a server, a video playback device, a video game console, a display device, a camera, or an appliance. For example, the optical package 1300 and various other electronic components may be electrically coupled to a circuit board within the electronic device.

It should be appreciated that optical package 1300 is merely presented as an example. In other embodiments, certain components may be omitted, added, rearranged, modified, or combined. For example, embodiments may include any number, combination, or arrangement of PICs and EICs (e.g., for higher bandwidth and/or redundancy), optical connectors, optical couplers, optical ferrules, optical interposers, fibers, bridges, XPUs or other computing components, substrates, surface cavities in the substrate, conductive contacts, conductive traces, vias, integrated circuit packages, and so forth.

### Example Embodiments

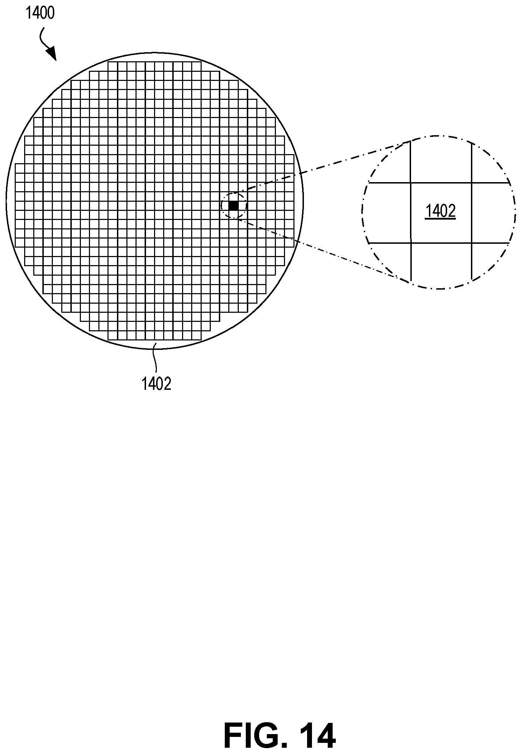

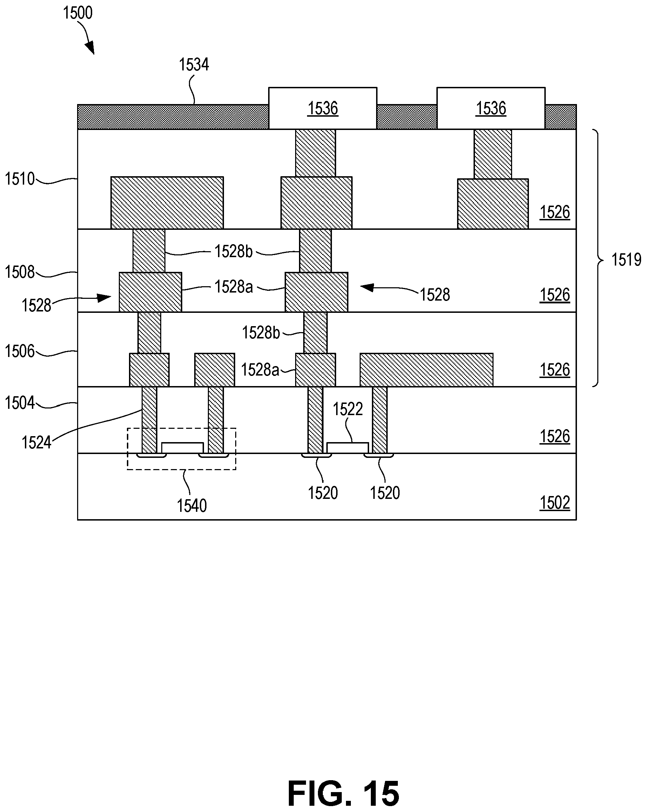

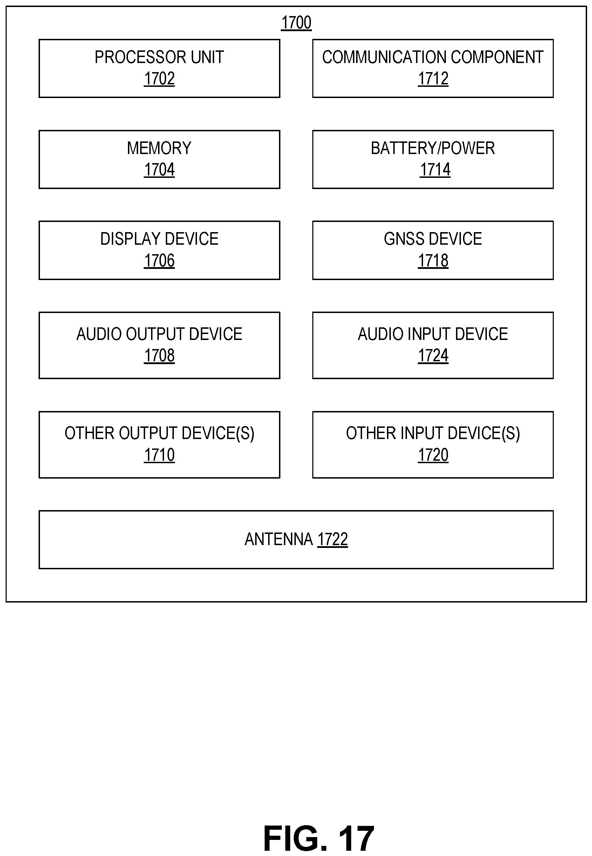

**FIG. 14** is a top view of a wafer 1400 and dies 1402 that may be included in any of the embodiments disclosed herein. The wafer 1400 may be composed of semiconductor material and may include one or more dies 1402 having integrated circuit structures formed on a surface of the wafer 1400. The individual dies 1402 may be a repeating unit of an integrated circuit product that includes any suitable integrated circuit. After the fabrication of the semiconductor product is complete, the wafer 1400 may undergo a singulation process in which the dies 1402 are separated from one another to provide discrete "chips" of the integrated circuit product. The die 1402 may be any of the dies disclosed herein. The die 1402 may include one or more transistors (e.g., some of the transistors 1540 of FIG. 15, discussed below), supporting circuitry to route electrical signals to the transistors, passive components (e.g., signal traces, resistors, capacitors, or inductors), and/or any other integrated circuit components. In some embodiments, the wafer 1400 or the die 1402 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1402. For example, a memory array formed by multiple memory devices may be formed on a same die 1402 as a processor unit (e.g., the processor unit 1702 of FIG. 17) or other logic that is configured to store information in the memory devices or execute instructions stored in the memory array. Various ones of the microelectronic assemblies disclosed herein may be manufactured using a die-to-wafer assembly technique in which some dies are attached to a wafer 1400 that include others of the dies, and the wafer 1400 is subsequently singulated.

**FIG. 15** is a cross-sectional side view of an integrated circuit device 1500 that may be included in any of the embodiments disclosed herein (e.g., in any of the dies). One or more of the integrated circuit devices 1500 may be included in one or more dies 1402 (FIG. 14). The integrated circuit device 1500 may be formed on a die substrate 1502 (e.g., the wafer 1400 of FIG. 14) and may be included in a die (e.g., the die 1402 of FIG. 14). The die substrate 1502 may be a semiconductor substrate composed of semiconductor material systems including, for example, n-type or p-type materials systems (or a combination of both). The die substrate 1502 may include, for example, a crystalline substrate formed using a bulk silicon or a silicon-on-insulator (SOI) substructure. In some embodiments, the die substrate 1502 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 1502. Although a few examples of materials from which the die substrate 1502 may be formed are described here, any material that may serve as a foundation for an integrated circuit device 1500 may be used. The die substrate 1502 may be part of a singulated die (e.g., the dies 1402 of FIG. 14) or a wafer (e.g., the wafer 1400 of FIG. 14).

The integrated circuit device 1500 may include one or more device layers 1504 disposed on the die substrate 1502. The device layer 1504 may include features of one or more transistors 1540 (e.g., metal oxide semiconductor field-effect transistors (MOSFETs)) formed on the die substrate 1502. The transistors 1540 may include, for example, one or more source and/or drain (S/D) regions 1520, a gate 1522 to control current flow between the S/D regions 1520, and one or more S/D contacts 1524 to route electrical signals to/from the S/D regions 1520. The transistors 1540 may include additional features not depicted for the sake of clarity, such as device isolation regions, gate contacts, and the like. The transistors 1540 are not limited to the type and configuration depicted in FIG. 15 and may include a wide variety of other types and configurations such as, for example, planar transistors, non-planar transistors, or a combination of both. Non- planar transistors may include FinFET transistors, such as double-gate transistors or tri-gate transistors, and wrap-around or all-around gate transistors, such as nanoribbon, nanosheet, or nanowire transistors.

A transistor 1540 may include a gate 1522 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1540 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1540 along the source-channel-drain direction, the gate electrode may consist of a U-shaped structure that includes a bottom portion substantially parallel to the surface of the die substrate 1502 and two sidewall portions that are substantially perpendicular to the top surface of the die substrate 1502. In other embodiments, at least one of the metal layers that form the gate electrode may simply be a planar layer that is substantially parallel to the top surface of the die substrate 1502 and does not include sidewall portions substantially perpendicular to the top surface of the die substrate 1502. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1520 may be formed within the die substrate 1502 adjacent to the gate 1522 of individual transistors 1540. The S/D regions 1520 may be formed using an implantation/diffusion process or an etching/deposition process, for example. In the former process, dopants such as boron, aluminum, antimony, phosphorous, or arsenic may be ion-implanted into the die substrate 1502 to form the S/D regions 1520. An annealing process that activates the dopants and causes them to diffuse farther into the die substrate 1502 may follow the ion-implantation process. In the latter process, the die substrate 1502 may first be etched to form recesses at the locations of the S/D regions 1520. An epitaxial deposition process may then be carried out to fill the recesses with material that is used to fabricate the S/D regions 1520. In some implementations, the S/D regions 1520 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1520 may be formed using one or more alternate semiconductor materials such as germanium or a group III-V material or alloy. In further embodiments, one or more layers of metal and/or metal alloys may be used to form the S/D regions 1520.

Electrical signals, such as power and/or input/output (I/O) signals, may be routed to and/or from the devices (e.g., transistors 1540) of the device layer 1504 through one or more interconnect layers disposed on the device layer 1504 (illustrated in FIG. 15 as interconnect layers 1506-1510). For example, electrically conductive features of the device layer 1504 (e.g., the gate 1522 and the S/D contacts 1524) may be electrically coupled with the interconnect structures 1528 of the interconnect layers 1506-1510. The one or more interconnect layers 1506-1510 may form a metallization stack (also referred to as an "ILD stack") 1519 of the integrated circuit device 1500.

The interconnect structures 1528 may be arranged within the interconnect layers 1506-1510 to route electrical signals according to a wide variety of designs; in particular, the arrangement is not limited to the particular configuration of interconnect structures 1528 depicted in FIG. 15. Although a particular number of interconnect layers 1506-1510 is depicted in FIG. 15, embodiments of the present disclosure include integrated circuit devices having more or fewer interconnect layers than depicted.

In some embodiments, the interconnect structures 1528 may include lines 1528a and/or vias 1528b filled with an electrically conductive material such as a metal. The lines 1528a may be arranged to route electrical signals in a direction of a plane that is substantially parallel with a surface of the die substrate 1502 upon which the device layer 1504 is formed. For example, the lines 1528a may route electrical signals in a direction in and out of the page and/or in a direction across the page from the perspective of FIG. 15. The vias 1528b may be arranged to route electrical signals in a direction of a plane that is substantially perpendicular to the surface of the die substrate 1502 upon which the device layer 1504 is formed. In some embodiments, the vias 1528b may electrically couple lines 1528a of different interconnect layers 1506-1510 together.

The interconnect layers 1506-1510 may include a dielectric material 1526 disposed between the interconnect structures 1528, as shown in FIG. 15. In some embodiments, dielectric material 1526 disposed between the interconnect structures 1528 in different ones of the interconnect layers 1506-1510 may have different compositions; in other embodiments, the composition of the dielectric material 1526 between different interconnect layers 1506-1510 may be the same. The device layer 1504 may include a dielectric material 1526 disposed between the transistors 1540 and a bottom layer of the metallization stack as well. The dielectric material 1526 included in the device layer 1504 may have a different composition than the dielectric material 1526 included in the interconnect layers 1506-1510; in other embodiments, the composition of the dielectric material 1526 in the device layer 1504 may be the same as a dielectric material 1526 included in any one of the interconnect layers 1506-1510.

A first interconnect layer 1506 (referred to as Metal 1 or "M1") may be formed directly on the device layer 1504. In some embodiments, the first interconnect layer 1506 may include lines 1528a and/or vias 1528b, as shown. The lines 1528a of the first interconnect layer 1506 may be coupled with contacts (e.g., the S/D contacts 1524) of the device layer 1504. The vias 1528b of the first interconnect layer 1506 may be coupled with the lines 1528a of a second interconnect layer 1508.

The second interconnect layer 1508 (referred to as Metal 2 or "M2") may be formed directly on the first interconnect layer 1506. In some embodiments, the second interconnect layer 1508 may include via 1528b to couple the lines 1528 of the second interconnect layer 1508 with the lines 1528a of a third interconnect layer 1510. Although the lines 1528a and the vias 1528b are structurally delineated with a line within individual interconnect layers for the sake of clarity, the lines 1528a and the vias 1528b may be structurally and/or materially contiguous (e.g., simultaneously filled during a dual-damascene process) in some embodiments.

The third interconnect layer 1510 (referred to as Metal 3 or "M3") (and additional interconnect layers, as desired) may be formed in succession on the second interconnect layer 1508 according to similar techniques and configurations described in connection with the second interconnect layer 1508 or the first interconnect layer 1506. In some embodiments, the interconnect layers that are "higher up" in the metallization stack 1519 in the integrated circuit device 1500 (i.e., farther away from the device layer 1504) may be thicker that the interconnect layers that are lower in the metallization stack 1519, with lines 1528a and vias 1528b in the higher interconnect layers being thicker than those in the lower interconnect layers.

The integrated circuit device 1500 may include a solder resist material 1534 (e.g., polyimide or similar material) and one or more conductive contacts 1536 formed on the interconnect layers 1506-1510. In FIG. 15, the conductive contacts 1536 are illustrated as taking the form of bond pads. The conductive contacts 1536 may be electrically coupled with the interconnect structures 1528 and configured to route the electrical signals of the transistor(s) 1540 to external devices. For example, solder bonds may be formed on the one or more conductive contacts 1536 to mechanically and/or electrically couple an integrated circuit die including the integrated circuit device 1500 with another component (e.g., a printed circuit board). The integrated circuit device 1500 may include additional or alternate structures to route the electrical signals from the interconnect layers 1506-1510; for example, the conductive contacts 1536 may include other analogous features (e.g., posts) that route the electrical signals to external components. The conductive contacts 1536 may serve as any of the conductive contacts described throughout this disclosure.

In some embodiments in which the integrated circuit device 1500 is a double-sided die, the integrated circuit device 1500 may include another metallization stack (not shown) on the opposite side of the device layer(s) 1504. This metallization stack may include multiple interconnect layers as discussed above with reference to the interconnect layers 1506-1510, to provide conductive pathways (e.g., including conductive lines and vias) between the device layer(s) 1504 and additional conductive contacts (not shown) on the opposite side of the integrated circuit device 1500 from the conductive contacts 1536. These additional conductive contacts may serve as any of the conductive contacts described throughout this disclosure.

In other embodiments in which the integrated circuit device 1500 is a double-sided die, the integrated circuit device 1500 may include one or more through silicon vias (TSVs) through the die substrate 1502; these TSVs may make contact with the device layer(s) 1504, and may provide conductive pathways between the device layer(s) 1504 and additional conductive contacts (not shown) on the opposite side of the integrated circuit device 1500 from the conductive contacts 1536. These additional conductive contacts may serve as any of the conductive contacts described throughout this disclosure. In some embodiments, TSVs extending through the substrate can be used for routing power and ground signals from conductive contacts on the opposite side of the integrated circuit device 1500 from the conductive contacts 1536 to the transistors 1540 and any other components integrated into the die 1500, and the metallization stack 1519 can be used to route I/O signals from the conductive contacts 1536 to transistors 1540 and any other components integrated into the die 1500.

Multiple integrated circuit devices 1500 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

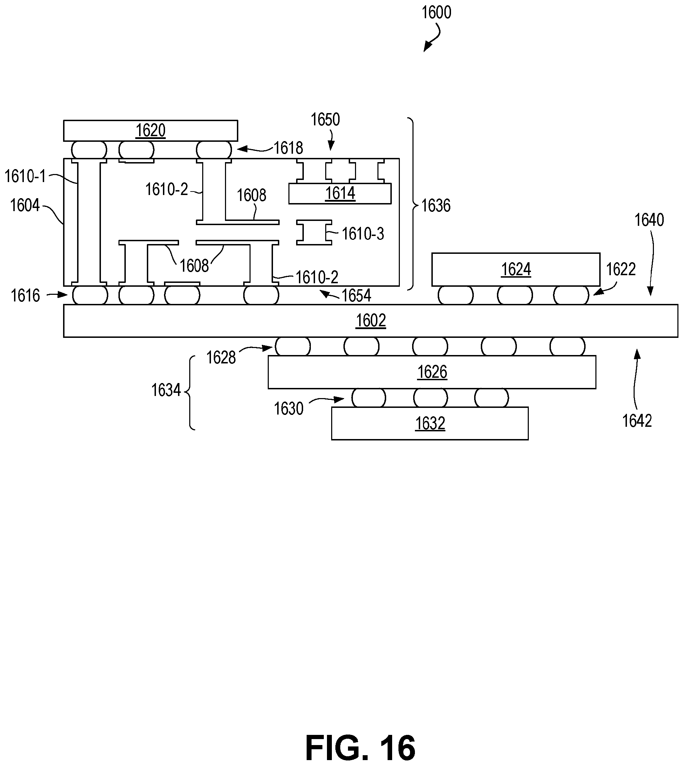

**FIG. 16** is a cross-sectional side view of an integrated circuit device assembly 1600 that may include any of the embodiments disclosed herein (e.g., optical and/or opto-electronic components selectively transferred from donor wafers). In some embodiments, the integrated circuit device assembly 1600 may be a microelectronic assembly. The integrated circuit device assembly 1600 includes a number of components disposed on a circuit board 1602 (which may be a motherboard, system board, mainboard, etc.). The integrated circuit device assembly 1600 includes components disposed on a first face 1640 of the circuit board 1602 and an opposing second face 1642 of the circuit board 1602; generally, components may be disposed on one or both faces 1640 and 1642. Any of the integrated circuit components discussed below with reference to the integrated circuit device assembly 1600 may take the form of any suitable ones of the embodiments of the microelectronic assemblies 100 disclosed herein.

In some embodiments, the circuit board 1602 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 1602. In other embodiments, the circuit board 1602 may be a non-PCB substrate. The integrated circuit device assembly 1600 illustrated in FIG. 16 includes a package-on-interposer structure 1636 coupled to the first face 1640 of the circuit board 1602 by coupling components 1616. The coupling components 1616 may electrically and mechanically couple the package-on-interposer structure 1636 to the circuit board 1602, and may include solder balls (as shown in FIG. 16), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. The coupling components 1616 may serve as the coupling components illustrated or described for any of the substrate assembly or substrate assembly components described herein, as appropriate.

The package-on-interposer structure 1636 may include an integrated circuit component 1620 coupled to an interposer 1604 by coupling components 1618. The coupling components 1618 may take any suitable form for the application, such as the forms discussed above with reference to the coupling components 1616. Although a single integrated circuit component 1620 is shown in FIG. 16, multiple integrated circuit components may be coupled to the interposer 1604; indeed, additional interposers may be coupled to the interposer 1604. The interposer 1604 may provide an intervening substrate used to bridge the circuit board 1602 and the integrated circuit component 1620.

The integrated circuit component 1620 may be a packaged or unpackaged integrated circuit product that includes one or more integrated circuit dies (e.g., the die 1402 of FIG. 14, the integrated circuit device 1500 of FIG. 15) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 1620, a single monolithic integrated circuit die comprises solder bumps attached to contacts on the die. The solder bumps allow the die to be directly attached to the interposer 1604. The integrated circuit component 1620 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 1620 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 1620 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 1620 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 1604 may spread connections to a wider pitch or reroute a connection to a different connection. For example, the interposer 1604 may couple the integrated circuit component 1620 to a set of ball grid array (BGA) conductive contacts of the coupling components 1616 for coupling to the circuit board 1602. In the embodiment illustrated in FIG. 16, the integrated circuit component 1620 and the circuit board 1602 are attached to opposing sides of the interposer 1604; in other embodiments, the integrated circuit component 1620 and the circuit board 1602 may be attached to a same side of the interposer 1604. In some embodiments, three or more components may be interconnected by way of the interposer 1604.

In some embodiments, the interposer 1604 may be formed as a PCB, including multiple metal layers separated from one another by layers of dielectric material and interconnected by electrically conductive vias. In some embodiments, the interposer 1604 may be formed of an epoxy resin, a fiberglass-reinforced epoxy resin, an epoxy resin with inorganic fillers, a ceramic material, or a polymer material such as polyimide. In some embodiments, the interposer 1604 may be formed of alternate rigid or flexible materials that may include the same materials described above for use in a semiconductor substrate, such as silicon, germanium, and other group III-V and group IV materials. The interposer 1604 may include metal interconnects 1608 and vias 1610, including but not limited to through hole vias 1610-1 (that extend from a first face 1650 of the interposer 1604 to a second face 1654 of the interposer 1604), blind vias 1610-2 (that extend from the first or second faces 1650 or 1654 of the interposer 1604 to an internal metal layer), and buried vias 1610-3 (that connect internal metal layers).

In some embodiments, the interposer 1604 can comprise a silicon interposer. Through silicon vias (TSV) extending through the silicon interposer can connect connections on a first face of a silicon interposer to an opposing second face of the silicon interposer. In some embodiments, an interposer 1604 comprising a silicon interposer can further comprise one or more routing layers to route connections on a first face of the interposer 1604 to an opposing second face of the interposer 1604.

The interposer 1604 may further include embedded devices 1614, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 1604. The package-on-interposer structure 1636 may take the form of any of the package-on-interposer structures known in the art. In embodiments where the interposer is a non-printed circuit board

The integrated circuit device assembly 1600 may include an integrated circuit component 1624 coupled to the first face 1640 of the circuit board 1602 by coupling components 1622. The coupling components 1622 may take the form of any of the embodiments discussed above with reference to the coupling components 1616, and the integrated circuit component 1624 may take the form of any of the embodiments discussed above with reference to the integrated circuit component 1620.

The integrated circuit device assembly 1600 illustrated in FIG. 16 includes a package-on-package structure 1634 coupled to the second face 1642 of the circuit board 1602 by coupling components 1628. The package-on-package structure 1634 may include an integrated circuit component 1626 and an integrated circuit component 1632 coupled together by coupling components 1630 such that the integrated circuit component 1626 is disposed between the circuit board 1602 and the integrated circuit component 1632. The coupling components 1628 and 1630 may take the form of any of the embodiments of the coupling components 1616 discussed above, and the integrated circuit components 1626 and 1632 may take the form of any of the embodiments of the integrated circuit component 1620 discussed above. The package-on-package structure 1634 may be configured in accordance with any of the package-on-package structures known in the art.

**FIG. 17** is a block diagram of an example electrical device 1700 that may include one or more of the embodiments disclosed herein. For example, any suitable ones of the components of the electrical device 1700 may include one or more selectively transferred optical and/or opto-electronic components, integrated circuit dies, integrated circuit device assemblies 1600, integrated circuit components 1620, integrated circuit devices 1500, or integrated circuit dies 1402 disclosed herein. A number of components are illustrated in FIG. 17 as included in the electrical device 1700, but any one or more of these components may be omitted or duplicated, as suitable for the application. In some embodiments, some or all of the components included in the electrical device 1700 may be attached to one or more motherboards mainboards, or system boards. In some embodiments, one or more of these components are fabricated onto a single system-on-a-chip (SoC) die.

Additionally, in various embodiments, the electrical device 1700 may not include one or more of the components illustrated in FIG. 17, but the electrical device 1700 may include interface circuitry for coupling to the one or more components. For example, the electrical device 1700 may not include a display device 1706, but may include display device interface circuitry (e.g., a connector and driver circuitry) to which a display device 1706 may be coupled. In another set of examples, the electrical device 1700 may not include an audio input device 1724 or an audio output device 1708, but may include audio input or output device interface circuitry (e.g., connectors and supporting circuitry) to which an audio input device 1724 or audio output device 1708 may be coupled.

The electrical device 1700 may include one or more processor units 1702 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1702 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1700 may include a memory 1704, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1704 may include memory that is located on the same integrated circuit die as the processor unit 1702. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1700 can comprise one or more processor units 1702 that are heterogeneous or asymmetric to another processor unit 1702 in the electrical device 1700. There can be a variety of differences between the processing units 1702 in a system in terms of a spectrum of metrics of merit including architectural, microarchitectural, thermal, power consumption characteristics, and the like. These differences can effectively manifest themselves as asymmetry and heterogeneity among the processor units 1702 in the electrical device 1700.

In some embodiments, the electrical device 1700 may include a communication component 1712 (e.g., one or more communication components). For example, the communication component 1712 can manage wireless communications for the transfer of data to and from the electrical device 1700. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1712 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1712 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1712 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1712 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1712 may operate in accordance with other wireless protocols in other embodiments. The electrical device 1700 may include an antenna 1722 to facilitate wireless communications and/or to receive other wireless communications (such as AM or FM radio transmissions).

In some embodiments, the communication component 1712 may manage wired communications, such as electrical, optical, or any other suitable communication protocols (e.g., IEEE 802.3 Ethernet standards). As noted above, the communication component 1712 may include multiple communication components. For instance, a first communication component 1712 may be dedicated to shorter-range wireless communications such as Wi-Fi or Bluetooth, and a second communication component 1712 may be dedicated to longer-range wireless communications such as global positioning system (GPS), EDGE, GPRS, CDMA, WiMAX, LTE, EV-DO, or others. In some embodiments, a first communication component 1712 may be dedicated to wireless communications, and a second communication component 1712 may be dedicated to wired communications.

The electrical device 1700 may include battery/power circuitry 1714. The battery/power circuitry 1714 may include one or more energy storage devices (e.g., batteries or capacitors) and/or circuitry for coupling components of the electrical device 1700 to an energy source separate from the electrical device 1700 (e.g., AC line power).

The electrical device 1700 may include a display device 1706 (or corresponding interface circuitry, as discussed above). The display device 1706 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1700 may include an audio output device 1708 (or corresponding interface circuitry, as discussed above). The audio output device 1708 may include any embedded or wired or wirelessly connected external device that generates an audible indicator, such speakers, headsets, or earbuds.

The electrical device 1700 may include an audio input device 1724 (or corresponding interface circuitry, as discussed above). The audio input device 1724 may include any embedded or wired or wirelessly connected device that generates a signal representative of a sound, such as microphones, microphone arrays, or digital instruments (e.g., instruments having a musical instrument digital interface (MIDI) output). The electrical device 1700 may include a Global Navigation Satellite System (GNSS) device 1718 (or corresponding interface circuitry, as discussed above), such as a Global Positioning System (GPS) device. The GNSS device 1718 may be in communication with a satellite-based system and may determine a geolocation of the electrical device 1700 based on information received from one or more GNSS satellites, as known in the art.

The electrical device 1700 may include other output device(s) 1710 (or corresponding interface circuitry, as discussed above). Examples of the other output device(s) 1710 may include an audio codec, a video codec, a printer, a wired or wireless transmitter for providing information to other devices, or an additional storage device.

The electrical device 1700 may include other input device(s) 1720 (or corresponding interface circuitry, as discussed above). Examples of the other input device(s) 1720 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1700 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1700 may be any other electronic device that processes data. In some embodiments, the electrical device 1700 may comprise multiple discrete physical components. Given the range of devices that the electrical device 1700 can be manifested as in various embodiments, in some embodiments, the electrical device 1700 can be referred to as a computing device or a computing system.

Illustrative examples of the technologies described throughout this disclosure are provided below. Embodiments of these technologies may include any one or more, and any combination of, the examples described below. In some embodiments, at least one of the systems or components set forth in one or more of the preceding figures may be configured to perform one or more operations, techniques, processes, and/or methods as set forth in the following examples.

Example 1 includes a microelectronic assembly, comprising: one or more optical waveguides; a photodetector to convert optical signals received on the one or more optical waveguides into electric current; a transimpedance amplifier (TIA) to convert the electric current into voltage; and an electronic integrated circuit (EIC) to output a digital signal based on the voltage, wherein the EIC and the TIA are on separate integrated circuit (IC) dies.

Example 2 includes the microelectronic assembly of Example 1, further comprising a mesa structure under the TIA, wherein the mesa structure has a similar footprint as the TIA.

Example 3 includes the microelectronic assembly of Example 2, wherein: the mesa structure comprises at least one of a dielectric material or a metal; and the TIA is bonded to the mesa structure via a dielectric bond, a metal bond, or a hybrid dielectric and metal bond.

Example 4 includes the microelectronic assembly of any of Examples 1-3, further comprising a mesa structure under the photodetector, wherein the mesa structure has a similar footprint as the photodetector.

Example 5 includes the microelectronic assembly of any of Examples 1-4, wherein: the TIA is adjacent to the photodetector; or the TIA is over the photodetector.

Example 6 includes the microelectronic assembly of any of Examples 1-5, wherein: the TIA has a thickness of 5 micrometers (µm) or less; or the TIA has an area of less than 1 millimeter (mm)².

Example 7 includes the microelectronic assembly of any of Examples 1-6, further comprising: a modulator to modulate optical signals for transmission on the one or more optical waveguides; and a driver to control the modulator, wherein the driver and the EIC are on separate IC dies.

Example 8 includes the microelectronic assembly of Example 7, further comprising a mesa structure under the driver, wherein the mesa structure has a similar footprint as the driver.

Example 9 includes the microelectronic assembly of any of Examples 1-8, wherein the EIC comprises one or more of: carrier phase recovery circuitry; clock and data recovery circuitry; error correction circuitry; serializer and deserializer circuitry; equalizer circuitry; sampler circuitry; mixer circuitry, amplifier circuitry; temperature control circuitry; or analog-to-digital and digital-to-analog conversion circuitry.

Example 10 includes the microelectronic assembly of any of Examples 1-9, further comprising: a processing unit; and an optical transceiver to send and receive optical signals on behalf of the processing unit, wherein the optical transceiver comprises the one or more optical waveguides, the photodetector, the TIA, and the EIC.

Example 11 includes an electronic device, comprising: a plurality of integrated circuit (IC) components, wherein the plurality of IC components include: a plurality of optical waveguides; a ring resonator to modulate optical signals for transmission on one or more of the optical waveguides; a driver to control the ring resonator; a photodetector to convert optical signals received on one or more of the optical waveguides into electric current; and a transimpedance amplifier (TIA) to convert the electric current into voltage; and one or more mesa structures under one or more of the plurality of IC components, wherein individual mesa structures are under a corresponding IC component of the plurality of IC components and have a similar footprint as the corresponding IC component.

Example 12 includes the electronic device of Example 11, wherein: individual mesa structures comprise at least one of a dielectric material or a metal; and individual IC components are bonded to individual mesa structures via a dielectric bond, a metal bond, or a hybrid dielectric and metal bond.

Example 13 includes the electronic device of any of Examples 11-12, wherein: the plurality of IC components further include an electronic integrated circuit (EIC) to output a digital signal based on the voltage; and the EIC, the TIA, and the driver are on separate IC dies.

Example 14 includes the electronic device of any of Examples 11-13, wherein the electronic device is an optical transceiver.

Example 15 includes the electronic device of any of Examples 11-13, wherein the plurality of IC components further include a processing unit, wherein the processing unit comprises a central processing unit, a graphics processing unit, an application-specific integrated circuit, or a field-programmable gate array.

Example 16 includes a method, comprising: receiving a first substrate, wherein the first substrate comprises a release layer and a layer of integrated circuit (IC) components over the release layer, wherein the layer of IC components comprises one or more optical waveguides, ring resonators, drivers, photodetectors, transimpedance amplifiers, or electronic integrated circuits; receiving a second substrate, wherein the second substrate comprises one or more adhesive areas; partially bonding the first substrate to the second substrate, wherein one or more IC components on the first substrate are bonded to the one or more adhesive areas on the second substrate, wherein the one or more IC components are from the layer of IC components; and separating the first substrate from the second substrate, wherein the one or more IC components are separated from the first substrate and remain on the second substrate.

Example 17 includes the method of Example 16, further comprising, before separating the first substrate from the second substrate: weakening the release layer using a laser; or removing portions of the release layer using a laser.

Example 18 includes the method of any of Examples 16-17, wherein the release layer comprises at least one of a metallic layer or a dielectric layer.

Example 19 includes the method of any of Examples 16-18, wherein receiving the first substrate comprises forming the first substrate, wherein forming the first substrate comprises: receiving a base substrate; forming the release layer over the base substrate; forming or transferring the layer of IC components over the release layer; and partially singulating the layer of IC components.

Example 20 includes the method of any of Examples 16-19, wherein the one or more adhesive areas include one or more raised structures, wherein the one or more raised structures comprise at least one of a dielectric material or a metal.

While the concepts of the present disclosure are susceptible to various modifications and alternative forms, specific embodiments thereof have been shown by way of example in the drawings and are described herein in detail. It should be understood, however, that there is no intent to limit the concepts of the present disclosure to the particular forms disclosed, but on the contrary, the intention is to cover all modifications, equivalents, and alternatives consistent with the present disclosure and the appended claims.

In the drawings, some structural or method features may be shown in specific arrangements and/or orderings. However, it should be appreciated that such specific arrangements and/or orderings may not be required. Rather, in some embodiments, such features may be arranged in a different manner and/or order than shown in the illustrative figures. Additionally, the inclusion of a structural or method feature in a particular figure is not meant to imply that such feature is required in all embodiments and, in some embodiments, may not be included or may be combined with other features. Further, it should be understood that the various embodiments shown in the figures are illustrative representations and are not necessarily drawn to scale.

Moreover, the illustrations and/or descriptions of various embodiments may be simplified or approximated for ease of understanding, and as a result, they may not necessarily reflect the level of precision nor variation that may be present in actual embodiments. For example, while some figures generally indicate straight lines, right angles, and smooth surfaces, actual implementations of the disclosed embodiments may have less than perfect straight lines and right angles, and some features may have surface topography or otherwise be non-smooth, given real-world limitations of fabrication processes. Similarly, illustrations and/or descriptions of how components are arranged may be simplified or approximated for ease of understanding and may vary by some margin of error in actual embodiments (e.g., due to fabrication processes, etc.).

Unless otherwise specified, the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

The terms "substantially," "close," "approximately," "near," and "about," generally refer to being within +/- 10% of a target value (unless otherwise specified). Similarly, terms describing spatial relationships, such as "perpendicular," "orthogonal," or "coplanar," may refer to being substantially within the described spatial relationships (e.g., within +/- 10 degrees of orthogonality).

Certain terminology may also be used in the foregoing description for the purpose of reference only, and thus are not intended to be limiting. For example, terms such as "upper," "lower," "above," "below," "bottom," and "top" refer to directions in the drawings to which reference is made. Terms such as "front," "back," "rear," and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

The terms "over", "under", "between", "adjacent", "to", and "on" as used herein may refer to a relative position of one layer or component with respect to other layers or components. For example, one layer "over", "under", or "on" another layer, "adjacent" to another layer, or bonded "to" another layer may be directly in contact with the other layer or may have one or more intervening layers. One layer "between" layers may be directly in contact with the layers or may have one or more intervening layers.

The meaning of "a," "an," and "the" include plural references. The meaning of "in" includes "in" and "on."

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional", "profile" and "plan" correspond to orthogonal planes within a cartesian coordinate system. Thus, cross-sectional and profile views are taken in the x-z plane, and plan views are taken in the x-y plane. Typically, profile views in the x-z plane are cross-sectional views.

The term "package" generally refers to a self-contained carrier of one or more dice, where the dice are attached to or embedded in the package substrate, and may be encapsulated for protection, with integrated or wire-bonded interconnects between the dice, along with leads, pins, or bumps located on the external portions of the package substrate. The package may contain a single die, or multiple dice, providing respective functions. The package may be mounted on a printed circuit board for interconnection with other packaged integrated circuits and discrete components, forming a larger circuit.

The term "cored" generally refers to a substrate of an integrated circuit package built upon a board, card, or wafer comprising a non-flexible stiff material. Typically, a small printed circuit board is used as a core, upon which integrated circuit device and discrete passive components may be soldered. Typically, the core has vias extending from one side to the other, allowing circuitry on one side of the core to be coupled directly to circuitry on the opposite side of the core. The core may also serve as a platform for building up layers of conductors and dielectric materials.

The term "coreless" generally refers to a substrate of an integrated circuit package having no core. The lack of a core may allow for higher-density package architectures, as the through-vias may have relatively large dimensions and pitch compared to high-density interconnects.

The term "land side" generally refers to the side of the substrate of the integrated circuit package closest to the plane of attachment to a printed circuit board, motherboard, or other package. This is in contrast to the term "die side", which generally refers to the side of the substrate of the integrated circuit package to which the die or dice are attached.

The terms "dielectric" and "dielectric material" generally refer to any type or number of non-electrically conductive materials. In some cases, dielectric material may be used to make up the structure of a package substrate. For example, dielectric material may be incorporated into an integrated circuit package as layers of laminate film or as a resin molded over integrated circuit dice mounted on the substrate.

The term "metallization" generally refers to metal layers formed on, over, and/or through the dielectric material of the package substrate. The metal layers are generally patterned to form metal structures such as traces and bond pads. The metallization of a package substrate may be confined to a single layer or in multiple layers separated by layers of dielectric.

The term "bond pad" generally refers to metallization structures that terminate integrated traces and vias in integrated circuit packages and dies. The term "solder pad" may be occasionally substituted for "bond pad" and may carry the same or similar meaning.

The term "bump" generally refers to a conductive layer or structure formed on a bond pad, which is typically made of solder or metal and has a round or curved shape, hence the term "bump".

The term "substrate" generally refers to a planar platform comprising dielectric and/or metallization structures. A substrate may mechanically support and electrically couple one or more IC dies on a single platform, with encapsulation of the one or more IC dies by a moldable dielectric material. A substrate may include bumps or pads as bonding interconnects on one or both sides. For example, one side of the substrate, generally referred to as the "die side", may include bumps or pads for chip or die bonding. The opposite side of the substrate, generally referred to as the "land side", may include bumps or pads for bonding the package to a printed circuit board.

The term "assembly" generally refers to a grouping of parts into a single functional unit. For example, certain parts may be permanently bonded together, integrated together, and/or mechanically assembled (e.g., where parts may be removable) into a functional unit.

The terms "coupled" or "connected" means a direct or indirect connection, such as a direct electrical, mechanical, magnetic, or fluidic connection between the things that are connected or an indirect connection, through one or more passive or active intermediary devices.

The term "circuit" or "module" may refer to one or more passive and/or active components that are arranged to cooperate with one another to provide a desired function. The term "signal" may refer to at least one current signal, voltage signal, magnetic signal, or data/clock signal.

## Claims

1. An electronic device, comprising:
a plurality of integrated circuit (IC) components, wherein the plurality of IC components include:
a plurality of waveguides;
a ring resonator to modulate optical signals for transmission on one or more of the waveguides;
a driver to control the ring resonator;
a photodetector to convert optical signals received on one or more of the waveguides into electric current; and
a transimpedance amplifier (TIA) to convert the electric current into voltage; and
one or more mesa structures under one or more of the plurality of IC components, wherein individual mesa structures are under a corresponding IC component of the plurality of IC components and have a similar footprint as the corresponding IC component.

2. The electronic device of Claim 1, wherein:
individual mesa structures comprise at least one of a dielectric material or a metal; and
individual IC components are bonded to individual mesa structures via a dielectric bond, a metal bond, or a hybrid dielectric and metal bond.

3. The electronic device of any of Claims 1-2, wherein the plurality of IC components further include an electronic integrated circuit (EIC) to output a digital signal based on the voltage.

4. The electronic device of Claim 3, wherein the EIC and the TIA are on separate IC dies.

5. The electronic device of any of Claims 3-4, wherein the EIC and the driver are on separate IC dies.

6. The electronic device of any of Claims 3-5, wherein the EIC comprises one or more of:
carrier phase recovery circuitry;
clock and data recovery circuitry;
error correction circuitry;
serializer and deserializer circuitry;
equalizer circuitry;
sampler circuitry; or
mixer circuitry.

7. The electronic device of any of Claims 1-6, wherein the plurality of IC components further include a processing unit, wherein the processing unit comprises a central processing unit, a graphics processing unit, an application-specific integrated circuit, or a field-programmable gate array.

8. The electronic device of Claim 7, further comprising:
an optical transceiver to send and receive optical signals on behalf of the processing unit, wherein the optical transceiver comprises the plurality of waveguides, the ring resonator, the driver, the photodetector, and the TIA.

9. The electronic device of any of Claims 1-6, wherein the electronic device is an optical transceiver.

10. The electronic device of any of Claims 1-9, wherein:
the TIA is adjacent to the photodetector; or
the TIA is over the photodetector.

11. The electronic device of any of Claims 1-10, wherein:
the TIA has a thickness of 5 micrometers (µm) or less; or
the TIA has an area of less than 1 millimeter (mm)².

12. The electronic device of any of Claims 1-11, wherein at least one of the mesa structures is under the TIA, the photodetector, or the driver.

13. A method of forming an electronic device as claimed in any preceding claim.

14. At least one machine-accessible storage medium having instructions stored thereon, wherein the instructions, when executed on a machine, cause the machine to perform a method or realize an apparatus as claimed in any preceding claim.
